# EUROPEAN PATENT SPECIFICATION

(11) **EP 3 001 227 B1**
(45) Date of publication and mention of the grant of the patent: **28.11.2018**
(21) Application number: 14801695.9
(22) Date of filing: 20.05.2014
(51) Int. Cl.: G02B 3/00, B32B 7/02, C08F 2/50, H01L 51/50, H05B 33/02

(54) **OPTICAL FILM, METHOD FOR PRODUCING OPTICAL FILM, AND SURFACE LIGHT-EMITTING BODY**
OPTISCHE FOLIE, VERFAHREN ZUR HERSTELLUNG EINER OPTISCHEN FOLIE UND OBERFLÄCHENLICHTEMITTIERENDER KÖRPER
FILM OPTIQUE, PROCÉDÉ DE PRODUCTION DE FILM OPTIQUE, ET CORPS À SURFACE ÉLECTROLUMINESCENTE

(30) Priority: 23.05.2013 JP 2013108607
(43) Date of publication of application: 30.03.2016
(73) Proprietor: Mitsubishi Chemical Corporation, Tokyo 100-8251 (JP)
(72) Inventor: OKUNO Daichi, Yokohama-shi Kanagawa 230-0053 (JP); TODA Masatoshi, Tokyo 100-8253 (JP)
(74) Representative: TBK
(86) International application number: PCT/JP2014/063310
(87) International publication number: WO 2014/189035

(56) References cited:
- EP-A1- 2 787 374
- WO-A1-2013/005769
- JP-A- H0 772 808
- JP-A- H01 302 201
- JP-A- H11 156 869
- JP-A- 2000 156 486
- JP-A- 2000 227 506
- JP-A- 2010 515 778
- JP-A- 2013 003 300
- US-A1- 2004 012 734
- US-A1- 2004 185 588
- US-A1- 2006 187 552

## Description

### TECHNICAL FIELD

The present invention relates to an optical film, a method for producing an optical film, and a surface light-emitting body.

This application claims priority based on Japanese Patent Application No. 2013-108607 which has been filed in Japan on May 23, 2013, and the content of which is incorporated herein by reference.

### BACKGROUND ART

Among surface light-emitting bodies, an organic electroluminescent (EL) element is expected to be used in a flat panel display and also in a new generation lighting device that is used in place of a fluorescent bulb and the like.

The structure of the organic EL element is diversified, that is, from a simple structure in which an organic thin film to be a light emitting layer is merely interposed between two electrodes to a structure in which a light emitting layer is provided and an organic thin film is multi-layered. As an example of the latter multi-layered structure, those obtained by laminating a hole transporting layer, a light emitting layer, an electron transporting layer, and a negative electrode on a positive electrode formed on a glass substrate are exemplified. The layer interposed between the positive electrode and the negative electrode entirely consists of an organic thin film, and the thickness of each organic thin film is extremely thin.

The organic EL element is a laminate of thin films, and based on a difference in refractive index between materials of each thin film, the total reflection angle of the light between the thin films is determined. Under the current circumstances, about 80% of the light generated from the light emitting layer is trapped inside the organic EL element and cannot be extracted to the outside. Specifically, when the refractive index of the glass substrate is 1.5 and the refractive index of an air layer is 1.0, a critical angle θc is 41.8° and the light with the incidence angle lower than the critical angle θc is emitted from the glass substrate to the air layer. However, the light with the incidence angle higher than the critical angle θc undergoes total reflection and is trapped inside the glass substrate. For such reasons, it has been desired to extract the light trapped inside the glass substrate on the surface of the organic EL element to the outside of the glass substrate, that is, to improve light extraction efficiency.

Patent Document 1 proposes an optical film having a microlens which is covered with an outer layer formed by a vapor deposition substance with a low refractive index, in order to improve luminance of a surface light-emitting body. Patent Document 2 proposes an optical film having a lens unit including fine particles, in order to maintain uniformity of luminance of a surface light-emitting body. EP2787374 (A1) (Art. 54(3) EPC) relates to an optical film that is provided with a plurality of aligned convex microlenses, each of which has a region α and a region β, said region forming the outer part of the convex shape of the microlens and positioned so as to cover the region α, wherein this optical film is characterized in that: both the region α and the region contain a resin, and the refractive index (η₁) of the resin in the region α is higher than the refractive index (η₂) of the resin in the region β; the region contains fine particles, and if necessary, the region α contains fine particles, and the content (P₁) of the fine particles contained in the region α is lower than the content (P₂) of the fine particles contained in the region β; or the region α contains fine particles, and if necessary, the region contains fine particles, and the content (P₁) of the fine particles contained in the region α is higher than the content (P₂) of the fine particles contained in the region β.
US2006187552 (A1) relates to a composite structure for light diffusion, including at least one carrier media layer and a microlens system comprising a plurality of microlenses thereon. A transparent material for enlarging the shape is coated on each micro-lens to cover the gaps between the microlens. Partial surface of the transparent material can be coated a light absorbing layer for glare reduction. Besides, the microlens can be or asymmetric or arranged in random, non-periodic array for interference reduction. US2004185588 (A1) relates to a solid-state imaging device including a plurality of two-dimensionally arranged photo diodes and a plurality of microlenses having substantially hemispherical shapes which cover the respective photo diodes. The microlens has a multilayer structure including at least a transparent resin upper layer which forms at least a portion of the substantially hemispherical shape, and a colored lower layer provided on a portion of the transparent resin upper layer which is located above the photo diode, with an interface between the colored lower layer and the transparent resin upper layer having a shape conforming to a surface of the photo diode.
JP2000-156486 (A) relates to a teaching wherein a silicon wafer is set oppositely to an electron beam deposition source. A deposition material for composing an antireflection film contained in the crucible of the electron beam deposition source is heated with an electron beam from a filament and evaporated to produce a vapor flow. The vapor flow is irradiated with an electron beam from an electron gun and excited energetically in order to form an antireflection film on the micro-lens of the silicon wafer under activated state. Since deposition takes place while being irradiated with an electron beam, the deposition material can form an antireflection film under activated state without raising the temperature of the micro-lens. Consequently, adhesion of the antireflection film can be improved while preventing cracking.
US2004012734 (A1) relates to a method of producing a microlens array includes a patterning step of forming a first optical resin layer having a first refractive index on a transparent substrate and forming a plurality of microlens planes arrayed in a two-dimensional pattern on the front surface of the first optical resin layer; a planarizing step of forming a planarized second optical resin layer; a joining step of providing a support layer on which a transparent protective film is previously formed; and a removing step of removing the support layer in such a manner that only the protective film remains on the second optical resin layer.; The planarizing step is performed by filling irregularities of the microlens planes with a resin having a second refractive index and planarizing the front surface, opposed to the microlens planes, of the resin, to form the planarized second optical resin layer, and the joining step is performed by joining the support layer to the planarized second optical resin layer.

### CITATION LIST

### PATENT DOCUMENT

Patent Document 1: JP 2011-123204 A
Patent Document 2: JP 2009-25774 A

### SUMMARY OF THE INVENTION

### PROBLEM TO BE SOLVED BY THE INVENTION

However, regarding the optical films proposed in Patent Document 1 and Patent Document 2, improvement in optical properties, for example, improvement in luminance and uniformity of luminance are achieved but it cannot be said that improvement in other physical properties is sufficient.

Since such an optical film is covered on an outer portion in many cases, physical properties by which an external load can be endured, such as impact resistance, a low curling property, abrasion resistance, an antifouling property, flame resistance, an antistatic property, and weather resistance, are necessary. Furthermore, since such an optical film is attached to a base material or the like for use, adhesiveness with the base material or the like is necessary.

An object of the invention is to provide an optical film which is excellent in an optical property, particularly, light extraction efficiency, of a surface light-emitting body and excellent in various physical properties, particularly, adhesiveness, impact resistance, a low curling property, abrasion resistance, an antifouling property, flame resistance, an antistatic property, and weather resistance.

Furthermore, another object of the invention is to provide a method suitable for producing the optical film.

Further, still another object of the invention is to provide a surface light-emitting body which is excellent in an optical property, particularly, light extraction efficiency.

### MEANS FOR SOLVING PROBLEM

(1) An optical film including a base material and a plurality of convex microlenses arranged on the base material, the microlens having an α-region and a β-region, the β-region occupying the outer portion of the convex shape of the microlens and being positioned so as to cover the α-region, in which
   a resin composition constituting the α-region has a test result of class 0 or class 1 in an adhesion test in conformity with ISO 2409 for measuring adhesiveness between the base material and the resin composition constituting the α-region, an average value of curls at four corners when the 50 mm-square optical film is dried at 60°C for 4 hours is 1.0 mm or less, a resin composition constituting the α-region includes at least one unit selected from the group consisting of a polyoxyalkylene glycol di(meth)acrylate unit, a polyester polyol di(meth)acrylate unit, and an aromatic ester diol di(meth)acrylate unit, and the base material is made from one selected from the group consisting of an acrylic resin, a polycarbonate resin, a polyester resin, a styrene resin, a vinyl chloride resin, a cellulose resin, and an imide resin.
(2) The optical film described in (1), in which the resin composition constituting the α-region further includes at least one unit selected from the group consisting of a monomer unit having a bisphenol skeleton and a polyfunctional urethane (meth)acrylate unit.
(3) The optical film described in (1) or (2), further including a urethane-based primer layer between the base material and the microlens.
(4) The optical film described in (1), in which the total content ratio of the polyoxyalkylene glycol di(meth)acrylate unit, the polyester polyol di(meth)acrylate unit, and the aromatic ester diol di(meth)acrylate unit to the total mass of the resin composition constituting the α-region is 10% by mass or more.
(5) The optical film according to claim 1, in which
   a difference in light extraction efficiency of a surface light-emitting body before and after a rubbing test of reciprocating a waste cloth 1000 times with a weight of 200 g on the β-region of the optical film is -0.01% to 0.01%.
(6) The optical film described in (5), in which a resin composition constituting the β-region includes a trifunctional or higher polyfunctional (meth)acrylate unit.
(7) The optical film described in (6), in which the trifunctional or higher polyfunctional (meth)acrylate unit is at least one trifunctional or higher polyfunctional (meth)acrylate unit selected from the group consisting of pentaerythritol tri(meth)acrylate, dipentaerythritol penta(meth)acrylate, dipentaerythritol hexa(meth)acrylate, and tris(2-(meth)acryloyloxyethyl)isocyanurate.
(8) The optical film described in (6) or (7), in which a content ratio of the trifunctional or higher polyfunctional (meth)acrylate unit to the total mass of the resin composition constituting the β-region is 30% by mass or more.
(9) The optical film according to claim 1, in which a surface resistance value of the β-region in a resistivity test in conformity with IEC 60093 is 10¹³ Ω/cm² or less.
(10) The optical film described in (9), in which a resin composition constituting the β-region includes at least one material selected from the group consisting of an ionic liquid, a quaternary ammonium compound, an ionic surfactant, and a conductive polymer.
(11) The optical film described in (10), in which the resin composition constituting the β-region includes the ionic liquid.
(12) A method for producing the optical film described in any one of (1) to (11), the method including: while a roll mold having an outer peripheral surface on which a plurality of concave microlens transferring portions are arranged is rotated and a base material is allowed to travel in a rotational direction of the roll mold along the outer peripheral surface of the roll mold, coating the outer peripheral surface of the roll mold with an active energy ray curable composition B to fill a part of the concave shapes of the microlens transferring portions with the active energy ray curable composition B; supplying an active energy ray curable composition A to a space between the outer peripheral surface of the roll mold and the base material; irradiating a region between the outer peripheral surface of the roll mold and the base material with an active energy ray in a state where at least the active energy ray curable composition A is interposed between the outer peripheral surface of the roll mold and the base material to obtain cured products of the active energy ray curable composition A and the active energy ray curable composition B; and releasing the cured products from the roll mold.
(13) The method for producing the optical film described in (12), in which the application of the active energy ray curable composition B in the filling with the active energy ray curable composition B is coating for making the active energy ray curable composition B follow a surface of the concave microlens transferring portion on the outer peripheral surface of the roll mold.
(14) The method for producing the optical film described in (12) or (13), further including irradiating the active energy ray curable composition B with an active energy ray to cure the active energy ray curable composition B between the filling with the active energy ray curable composition B and the supplying of the active energy ray curable composition A.
(15) The method for producing the optical film described in any one of (12) to (14), in which a viscosity of the active energy ray curable composition B is lower than a viscosity of the active energy ray curable composition A.
(16) A surface light-emitting body including the optical film described in any one of (1) to (11).

### EFFECT OF THE INVENTION

The optical film of the invention is excellent in various physical properties, particularly, adhesiveness, impact resistance, a low curling property, abrasion resistance, an antifouling property, flame resistance, an antistatic property, and weather resistance.

The method for producing the optical film of the invention is suitable for producing the optical film described above.

The surface light-emitting body of the invention is excellent in an optical property, particularly, light extraction efficiency.

### BRIEF DESCRIPTION OF DRAWINGS

Fig. 1A is a schematic diagram illustrating an example of a convex microlens in an optical film of the invention;
Fig. 1B is a schematic diagram illustrating an example of the convex microlens in the optical film of the invention;
Fig. 2 is a schematic diagram illustrating an example of the optical film of the invention when viewed from the upper side of the optical film;
Fig. 3A is a schematic diagram illustrating an arrangement example of the microlens of the optical film of the invention when viewed from the upper side of the optical film;
Fig. 3B is a schematic diagram illustrating an arrangement example of the microlens of the optical film of the invention when viewed from the upper side of the optical film;
Fig. 3C is a schematic diagram illustrating an arrangement example of the microlens of the optical film of the invention when viewed from the upper side of the optical film;
Fig. 3D is a schematic diagram illustrating an arrangement example of the microlens of the optical film of the invention when viewed from the upper side of the optical film;
Fig. 3E is a schematic diagram illustrating an arrangement example of the microlens of the optical film of the invention when viewed from the upper side of the optical film;
Fig. 3F is a schematic diagram illustrating an arrangement example of the microlens of the optical film of the invention when viewed from the upper side of the optical film;
Fig. 4 is a schematic cross-sectional view illustrating an example of the optical film of the invention;
Fig. 5 is a schematic cross-sectional view illustrating an example of a surface light-emitting body of the invention; and
Fig. 6 is a schematic diagram illustrating an example of a method for producing the optical film of the invention.

### MODE(S) FOR CARRYING OUT THE INVENTION

Hereinafter, an embodiment of the invention will be described with reference to the drawings, but the invention is not limited to these drawings.

### (Convex Shape of Microlens)

An optical film of the invention has a plurality of convex microlenses 10 arranged therein.

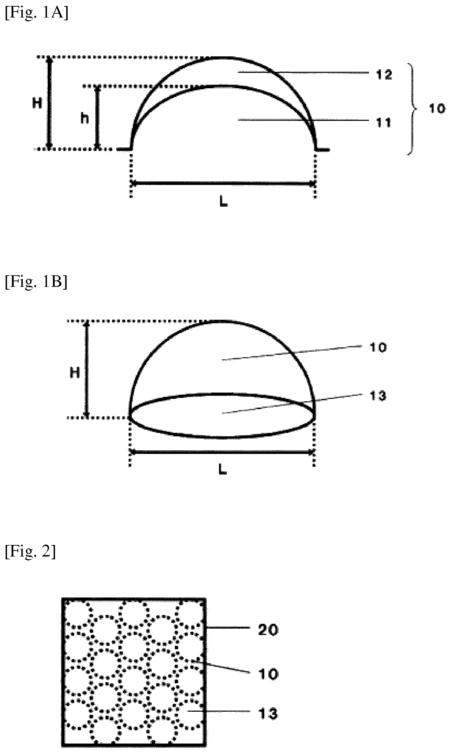

An example of the convex microlens 10 is illustrated in Fig. 1A and Fig. 1B. Fig. 1A is a schematic cross-sectional view and Fig. 1B is a schematic perspective view. The microlens 10 has an α-region 11 and a β-region 12. The β-region 12 occupies the outer portion of the convex shape of the microlens 10. The β-region 12 is positioned so as to cover the α-region 11.

It is preferable that the convex shape of the microlens 10 be formed by the outer face of the β-region 12, that is, the upper face in Fig. 1A. However, the convex shape of the microlens 10 is not limited thereto. The α-region 11 is not completely covered with the β-region 12 but a part of the α-region 11 is exposed to the outside so as to form a part of the surface of the microlens 10. In this case, the convex shape of the microlens 10 is formed by the outer face of the β-region 12 and the outer face of the α-region 11.

In the present specification, a bottom surface portion 13 of the microlens 10 is a virtual planar portion surrounded by an outer peripheral edge of a bottom portion of the microlens 10. In a case where the optical film has a base layer 21 to be described later, the bottom surface portion 13 of the microlens 10 corresponds to an interface between the microlens 10 and the base layer 21.

Furthermore, in the present specification, a maximum diameter L of the bottom surface portion 13 of the microlens 10 indicates a length of the longest part of the bottom surface portion 13 of the microlens 10, and an average maximum diameter Lₐᵥₑ of the bottom surface portion 13 of the microlens 10 is obtained by photographing the surface, which has the microlens 10, of the optical film by a scanning microscope, measuring the maximum diameter L of the bottom surface portion 13 of the microlens 10 at five positions, and averaging the values thus measured.

Furthermore, in the present specification, a height H of the microlens 10 indicates a height from the bottom surface portion 13 of the microlens 10 to the highest part of the microlens 10, and an average height Hₐᵥₑ of the microlens 10 is obtained by photographing the cross section of the optical film by a scanning microscope, measuring the height H of the microlens 10 at five positions, and averaging the values thus measured.

Further, in the present specification, a height h of the α-region 11 indicates a height from the bottom surface portion 13 of the microlens 10 to the highest part of the α-region 11, and an average height hₐᵥₑ of the α-region 11 is obtained by photographing the cross section of the optical film by a scanning microscope, measuring the height h of the α-region 11 at five positions, and averaging the values thus measured.

Examples of the convex shape of the microlens 10 include a spherical segment shape, a spherical segment trapezoidal shape, an ellipsoid spherical segment shape (a shape obtained by cutting a spheroid with one plane), an ellipsoid spherical segment trapezoidal shape (a shape obtained by cutting a spheroid with two planes that are parallel to each other), a pyramid shape, a pyramid trapezoidal shape, a conical shape, a conical trapezoidal shape, and roof-like shapes relating to these shapes (a shape in which a spherical segment shape, a spherical segment trapezoidal shape, an ellipsoid spherical segment shape, an ellipsoid spherical segment trapezoidal shape, a pyramid shape, a pyramid trapezoidal shape, a conical shape, or a conical trapezoidal shape extends along a bottom surface portion). These convex shapes of the microlens 10 may be used alone or in combination of two or more kinds thereof with respect to the plurality of microlenses 10. Among these convex shapes of the microlens 10, from the viewpoint of having excellent light extraction efficiency of the surface light-emitting body, a spherical segment shape, a spherical segment trapezoidal shape, an ellipsoid spherical segment shape, and an ellipsoid spherical segment trapezoidal shape are preferable, and a spherical segment shape and an ellipsoid spherical segment shape are more preferable.

Incidentally, the spherical shape may not be a perfect spherical shape and may be a substantially spherical shape. The substantially spherical shape indicates a shape in which the surface of the spherical shape is deviated from the surface of a virtual perfect sphere circumscribing the spherical shape or from the center of the virtual perfect sphere with respect to the normal direction, and the deviation amount thereof may be 0 to 20% relative to the radius of the virtual perfect sphere.

Furthermore, in a case where the shape is expressed as "ellipse" in the present specification, a circular shape in which a perfect circular shape extends in one direction or in multi-directions is also included.

The average maximum diameter Lₐᵥₑ of the bottom surface portion 13 of the microlens 10 is preferably 2 µm to 400 µm, more preferably 10 µm to 200 µm, and even more preferably 20 µm to 100 µm. When the average maximum diameter Lₐᵥₑ of the bottom surface portion 13 of the microlens 10 is 2 µm or more, the light extraction efficiency of the surface light-emitting body is excellent. In addition, when the average maximum diameter Lₐᵥₑ of the bottom surface portion 13 of the microlens 10 is 400 µm or less, the microlens 10 is not visually recognized and the appearance of the optical film is excellent.

The average height Hₐᵥₑ of the microlens 10 is preferably 1 µm to 200 µm, more preferably 5 µm to 100 µm, and even more preferably 10 µm to 50 µm. When the average height Hₐᵥₑ of the microlens 10 is 1 µm or more, the light extraction efficiency of the surface light-emitting body is excellent. In addition, when the average height Hₐᵥₑ of the microlens 10 is 200 µm or less, the flexibility of the optical film is excellent.

An aspect ratio of the microlens 10 is preferably 0.3 to 1.4, more preferably 0.35 to 1.3, and even more preferably 0.4 to 1.0. When the aspect ratio of the microlens 10 is 0.3 or more, the light extraction efficiency of the surface light-emitting body is excellent. In addition, when the aspect ratio of the microlens 10 is 1.4 or less, the transferring portion of the roll mold is easily formed and the production of the optical film is facilitated.

Incidentally, the aspect ratio of the microlens 10 is calculated from "the average height Hₐᵥₑ of the microlens 10/the average maximum diameter Lₐᵥₑ of the bottom surface portion of the microlens 10."

### (Bottom Surface Portion of Microlens)

Examples of the shape of the bottom surface portion 13 of the microlens 10 include a circular shape and an elliptical shape. These shapes of the bottom surface portion 13 of the convex microlens 10 may be used alone or in combination of two or more kinds thereof with respect to the plurality of microlenses 10. Among the shapes of the bottom surface portion 13 of the microlens 10, from the viewpoint of having excellent light extraction efficiency of the surface light-emitting body, a circular shape and an elliptical shape are preferable and a circular shape is more preferable.

Incidentally, the circular shape may not be a perfect circular shape and may be a substantially circular shape. The substantially circular shape indicates a shape in which the surface of the circular shape is deviated from the circumference of a virtual perfect circular shape circumscribing the circular shape with respect to the normal direction of the virtual perfect circular shape, and the deviation amount thereof may be 0 to 20% relative to the radius of the virtual perfect circular shape.

An example of the optical film viewed from the upper side thereof is illustrated in Fig. 2.

The ratio of the total area of the bottom surface portions 13 of the microlenses 10 (an area surrounded by a dotted line in Fig. 2) to an area of an optical film 20 (an area surrounded by a solid line in Fig. 2) is preferably 20 to 99%, more preferably 30 to 95%, and even more preferably 50 to 93%. When the ratio of the total area of the bottom surface portions 13 of the microlenses 10 to the area of the optical film 20 is 20% or more, the light extraction efficiency of the surface light-emitting body is excellent. In addition, when the ratio of the total area of the bottom surface portions 13 of the microlenses 10 to the area of the optical film 20 is 99% or less, the transferring portion of the roll mold is easily formed and the production of the optical film 20 is facilitated.

Incidentally, in a case where the bottom surface portions 13 of the microlenses 10 are all circular shapes of the same size, the maximum value of the ratio of the total area of the bottom surface portions of the microlenses 10 to the area of the optical film 20 is about 91%.

### (Arrangement of Microlens)

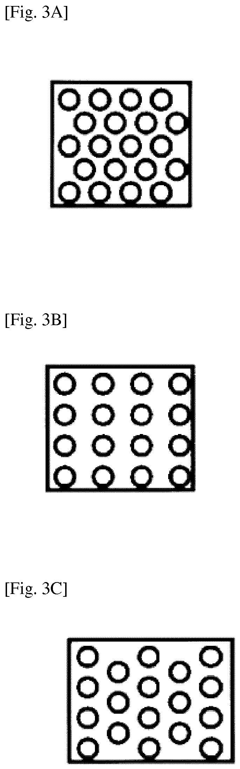

An arrangement example of the microlens 10 is illustrated in Fig. 3A to Fig. 3F.

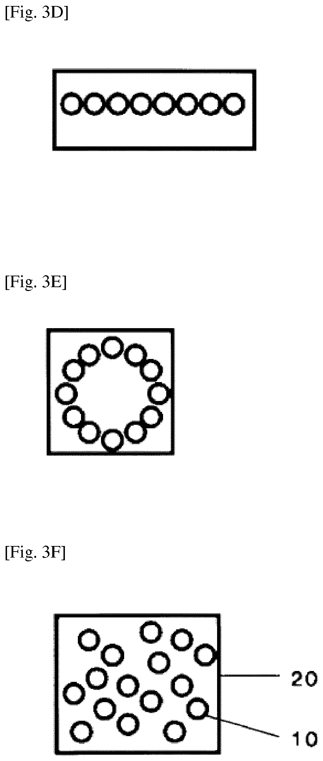

Examples of the arrangement of the microlens 10 include hexagonal alignment (Fig. 3A), rectangular alignment (Fig. 3B), diamond alignment (Fig. 3C), linear alignment (Fig. 3D), circular alignment (Fig. 3E), and random alignment (Fig. 3F). The hexagonal alignment indicates a case where a recessed and projected structure 13 is arranged at each vertex of a hexagonal shape and the center thereof and the arrangement of the hexagonal shape is continuously aligned. The rectangular alignment indicates a case where the recessed and projected structure 13 is arranged at each vertex of a rectangular shape and the arrangement of the rectangular shape is continuously aligned. The diamond alignment indicates a case where the recessed and projected structure 13 is arranged at each vertex of a diamond shape and the arrangement of the diamond shape is continuously aligned. The linear alignment indicates a case where the recessed and projected structure 13 is arranged in a linear shape. The circular alignment indicates a case where the recessed and projected structure 13 is arranged along the circle.

Among these examples of arrangement of the microlens 10, from the viewpoint of having excellent light extraction efficiency of the surface light-emitting body, hexagonal alignment, rectangular alignment, and diamond alignment are preferable, and hexagonal alignment and rectangular alignment are more preferable.

### (α-Region and β-Region)

The average height hₐᵥₑ of the α-region 11 is preferably 0.8 µm to 160 µm, more preferably 4 µm to 80 µm, and even more preferably 8 µm to 40 µm. When the average height hₐᵥₑ of the α-region 11 is 0.8 µm or more, performances (adhesiveness and impact resistance) imparted to the α-region of the optical film are excellent. In addition, when the average height hₐᵥₑ of the α-region 11 is 160 µm or less, performances (abrasion resistance, an antifouling property, flame resistance, an antistatic property, and weather resistance) imparted to the β-region of the optical film are excellent.

A ratio (hₐᵥₑ/Hₐᵥₑ) of the average height have of the α-region 11 to the average height Hₐᵥₑ of the microlens 10 is preferably 0.04 to 0.96, more preferably 0.1 to 0.92, and even more preferably 0.2 to 0.88. When the ratio of the average height hₐᵥₑ of the α-region 11 to the average height Hₐᵥₑ of the microlens 10 is 0.04 or more, the performances imparted to the α-region of the optical film are excellent. In addition, when the ratio of the average height have of the α-region 11 to the average height Hₐᵥₑ of the microlens 10 is 0.96 or less, the performances imparted to the β-region of the optical film are excellent.

A ratio of the volume of the α-region 11 to the volume of the microlens 10 is preferably 0.01 to 0.90, more preferably 0.02 to 0.80, and even more preferably 0.03 to 0.70. When the ratio of the volume of the α-region 11 to the volume of the microlens 10 is 0.01 or more, the performances imparted to the α-region of the optical film are excellent. In addition, when the ratio of the volume of the α-region 11 to the volume of the microlens 10 is 0.90 or less, the performances imparted to the β-region of the optical film are excellent.

Another region may be present between the α-region 11 and the β-region 12 in the microlens 10. The "another region" may be formed by a single layer or a plurality of layers. As the "another region," for example, an intermediate region for improving adhesiveness between the α-region and the β-region, or the like is exemplified.

### (α-Region)

The α-region is formed by a resin composition having at least the performance of adhesiveness and a low curling property.

Since the α-region of the present invention has a performance of adhesiveness, the microlens 10 (the base layer 21) and the base material 22 or the microlens 10 (the base layer 21) and a glass substrate 41 can be brought into close contact with each other, the structure stability of the surface light-emitting body is excellent, the adhesive layer 23 or the like cannot be provided, and productivity and bendability of the surface light-emitting body are excellent.

In the present specification, the "adhesiveness" is evaluated by an adhesion test in conformity with ISO 2409. Specifically, the evaluation is conducted by the following method.

11 cuts reaching the base material 22 are formed on a sample in which the α-region and the β-region are formed on the base material 22 using a cutter knife to form 100 grids of lattice pattern (cross cut). The interval of the cuts is set to 2 mm in this evaluation. An adhesive cellophane tape is pressed firmly onto the lattice pattern portion and the edge of the adhesive cellophane tape is peeled off at once at an angle of 45°. Thereafter, the state of the lattice pattern is compared with the standard drawing described in ISO 2409, and the adhesiveness is evaluated with six grades of class 0 to class 5. A case where a test result is class 0 indicates the highest adhesiveness, and a case where a test result is class 5 indicates the lowest adhesiveness.

In the present invention, regarding the adhesiveness of the optical film 20, the result of the adhesion test in conformity with ISO 2409 is class 0 or class 1, and class 0 is preferable. Class 0 indicates "The edges of the cuts are completely smooth and there was no peeling anywhere in any lattice cell." Class 1 indicates "There is only slight peeling of the coated film at the cross point of the cuts, and the affected cross-cut portion did not exceed 5% definitely."

The expression "influence affected on the cross-cut portion" described in the present specification indicates the degree of missing of the lattice pattern after the adhesive cellophane tape is peeled in the test.

In order to make the α-region have the performance of adhesiveness, it is desirable that the resin composition constituting the α-region include, for example, a monomer unit having a bisphenol skeleton or a monomer unit having a skeleton with adhesiveness, such as an aromatic (meth)acrylate unit.

Examples of a monomer for constituting the monomer unit having a bisphenol skeleton include ethylene oxide-modified bisphenol A di(meth)acrylate and propylene oxide-modified bisphenol A di(meth)acrylate.

Examples of a monomer for constituting the aromatic (meth)acrylate unit include ethoxylated fluorene (meth)acrylate, phenoxyethyl (meth)acrylate, benzyl (meth)acrylate, phenylglycidylether (meth)acrylate, phenylphenol (meth)acrylate, and ethoxylated phenylphenol (meth)acrylate.

The content ratio of the monomer unit having a skeleton with adhesiveness to the total mass of the resin composition constituting the α-region is preferably 10% by mass or more, more preferably 10% by mass to 90% by mass, and even more preferably 20% by mass to 80% by mass, from the viewpoint of having excellent adhesiveness of the microlens 10 (the base layer 21).

When the α-region has the performance of impact resistance, it is possible to suppress damage of the optical film 20.

The "impact resistance" in the present specification is evaluated by the following method.

In a dropping impact deformation test in conformity with ISO 6272, a 500 g ball is dropped from the height of 50 cm, the presence and absence of generation of cracking or peeling is determined, and a case not having cracking or peeling is considered to be excellent in impact resistance.

In order to make the α-region have the performance of impact resistance, it is desirable that the resin composition constituting the α-region include, for example, a monomer unit having flexibility such as a polyfunctional urethane (meth)acrylate unit.

Examples of the monomer for constituting the polyfunctional urethane (meth)acrylate unit include a compound obtained by a reaction between a diisocyanate compound (tolylene diisocyanate, isophorone diisocyanate, xylene diisocyanate, dicyclohexylmethane diisocyanate, hexamethylene diisocyanate, or the like) and a hydroxyl group-containing (meth)acrylate (polyfunctional(meth)acrylate such as 2-hydroxyethyl(meth)acrylate, 2-hydroxypropyl(meth)acrylate, 4-hydroxybutyl(meth)acrylate, or pentaerythritol tri(meth)acrylate) and a compound obtained by reacting a hydroxyl group-containing (meth)acrylate with an isocyanate group which has been left after adding a diisocyanate compound to a hydroxyl group of alcohols (one or two or more types of alkane diol, polyether diol, polyester diol, and a spiroglycol compound).

The content ratio of the monomer unit having flexibility to the total mass of the resin composition constituting the α-region is preferably 10% by mass or more, more preferably 10% by mass to 60% by mass, and even more preferably 20% by mass to 50% by mass, from the viewpoint that it is possible to suppress damage of the optical film 20.

Since the α-region has the performance of a low curling property, the curling of the optical film 20 can be suppressed and the productivity of the surface light-emitting body is excellent.

The "low curling property" in the present specification is evaluated by the following method.

The optical film 20 is cut into a size of 50 mm square, is dried at 60°C for 4 hours, is charge-removed by a blower for removal of electrostatic charge, and is left to stand still on a flat surface such that the surface having the microlens 10 faces upward. In this state, distances (curls) from the flat surface to respective four corners of the optical film 20 are measured by a height gauge. The curling property evaluation is based on an average value (mm) of the distances of respective four corners.

In the present invention, the curling property of the optical film 20 is 1.0 mm or less, preferably 0.01 mm to 1.0 mm, more preferably 0.03 mm to 0.9 mm, and even more preferably 0.05 mm to 0.8 mm.

In order to make the α-region have the performance of a low curling property, the resin composition constituting the α-region includes a low-modulus monomer unit selected from a polyalkylene glycol di(meth)acrylate unit, a polyester polyol dimethacrylate unit, or an aromatic ester diol di(meth)acrylate unit. These low-modulus monomer units may be used alone or in combination of two or more kinds thereof.

Examples of a monomer for constituting the polyalkylene glycol di(meth)acrylate unit include polyethylene glycol di(meth)acrylate, polypropylene glycol di(meth)acrylate, and polybutylene glycol di(meth)acrylate.

Among these low-modulus monomer units, from the viewpoint that it is possible to suppress the curling of the optical film 20, a polyalkylene glycol di(meth)acrylate unit, a polyester polyol dimethacrylate unit, or an aromatic ester diol di(meth)acrylate unit is used, and a polyalkylene glycol di(meth)acrylate unit is preferable.

From the viewpoint that it is possible to suppress the curling of the optical film 20 and the productivity of the surface light-emitting body is excellent, the content ratio of the low-modulus monomer unit to the total mass of the resin composition constituting the α-region is preferably 10% by mass or more, more preferably 10% by mass to 50% by mass, and even more preferably 15% by mass to 40% by mass.

From the viewpoint that it is possible to suppress the curling of the optical film 20 and the productivity of the surface light-emitting body is excellent, the total content ratio of the polyoxyalkylene glycol di(meth)acrylate unit, the polyester polyol di(meth)acrylate unit, and the aromatic ester diol di(meth)acrylate unit is preferably 10% by mass or more, more preferably 10% by mass to 50% by mass, and even more preferably 15% by mass to 40% by mass.

Regarding the material of the base material 22 for having the performance of a low curling property, in consideration of the combination of the base material 22 with the resin composition constituting the α-region, an acrylic resin, a polycarbonate resin, a polyester resin, a styrene resin, a vinyl chloride resin, a cellulose resin, or an imide resin is used, wherein an acrylic resin, a polycarbonate resin, a polyester resin, and an imide resin are preferable, and a polyester resin is more preferable.

Furthermore, the α-region may include first fine particles. The first fine particles included in the α-region are not particularly limited as long as they are fine particles having a light diffusion property in the wavelength range of visible light (about 400 nm to 700 nm) and known fine particles can be used. The first fine particles included in the α-region may be used alone or in combination of two or more kinds thereof.

Examples of a material of the first fine particles include metals such as gold, silver, silicon, aluminum, magnesium, zirconium, titanium, zinc, germanium, indium, tin, antimony, and cerium; metal oxides such as silicon oxide, aluminum oxide, magnesium oxide, zirconium oxide, titanium oxide, zinc oxide, germanium oxide, indium oxide, tin oxide, indium tin oxide, antimony oxide, and cerium oxide; metal hydroxides such as aluminum hydroxide; metal carbonates such as magnesium carbonate; metal nitrides such as silicon nitride; and resins such as an acrylic resin, a styrene resin, a silicone resin, a urethane resin, a melamine resin, and an epoxy resin. These materials of the fine particles may be used alone or in combination of two or more kinds thereof. Among these materials of the fine particles, from the viewpoint of excellent handlability at the time of producing the optical film 20, silicon, aluminum, magnesium, silicon oxide, aluminum oxide, magnesium oxide, aluminum hydroxide, magnesium carbonate, an acrylic resin, a styrene resin, a silicone resin, a urethane resin, a melamine resin, and an epoxy resin are preferable, and particles of silicon oxide, aluminum oxide, aluminum hydroxide, magnesium carbonate, an acrylic resin, a styrene resin, a silicone resin, a urethane resin, a melamine resin, and an epoxy resin are more preferable.

From the viewpoint of having an excellent light transmitting property of the optical film 20, the refractive index of the first fine particles included in the α-region is preferably 1.30 to 2.00, more preferably 1.35 to 1.95, and even more preferably 1.40 to 1.90. The refractive index of the first fine particles is a value measured by using a sodium D line at 20°C.

The volume average particle diameter of the first fine particles included in the α-region is preferably 0.5 µm to 20 µm, more preferably 1 µm to 15 µm, and even more preferably 1.5 µm to 10 µm. When the volume average particle diameter of the first fine particles included in the α-region is 0.5 µm or more, light in visible wavelength range can be effectively scattered. In addition, when the volume average particle diameter of the first fine particles included in the α-region is 20 µm or less, it is possible to suppress the emission angle dependence of the wavelength of light emitted from the surface light-emitting body.

Incidentally, in the present specification, the volume average particle diameter is a value measured by a coulter counter.

Examples of the shape of the first fine particles included in the α-region include a spherical shape, a column shape, a cubic shape, a rectangular shape, a pyramid shape, a cone shape, a star shape, and an amorphous shape. These shapes of the first fine particles included in the α-region may be used alone or in combination of two or more kinds thereof. Among these shapes of the first fine particles included in the α-region, from the viewpoint that light in visible wavelength range can be effectively scattered, a spherical shape, a cubic shape, a rectangular shape, a pyramid shape, and a star shape are preferable, and a spherical shape is more preferable.

The content ratio of the first fine particles included in the α-region to the total mass of the α-region is preferably 1% by mass to 50% by mass, more preferably 3% by mass to 45% by mass, and even more preferably 5% by mass to 40% by mass. When the content ratio of the first fine particles included in the α-region to the total mass of the α-region is 1% by mass or more, the light diffusion property of the optical film 20 is excellent and it is possible to suppress the emission angle dependence of the wavelength of light emitted from the surface light-emitting body. In addition, when the content ratio of the first fine particles included in the α-region to the total mass of the α-region is 50% by mass or less, the curling of the optical film 20 is suppressed and the light extraction efficiency or the luminance in the normal direction of the surface light-emitting body is excellent.

Incidentally, the content ratio of the first fine particles included in the α-region to the total mass of the α-region may be substantially the same as or different from the content ratio of the first fine particles included in an intermediate layer 25 to the total mass of the intermediate layer 25.

Furthermore, the weight average molecular weight of the resin composition constituting the α-region is preferably 500 or more, more preferably 1000 to 10000000, and even more preferably 2000 to 5000000.

### (β-Region)

The β-region is formed by a resin composition having at least one performance selected from abrasion resistance, an antifouling property, flame resistance, an antistatic property, and weather resistance.

When the β-region has abrasion resistance, it is possible to suppress scratches of the optical film 20 and the optical performance of the optical film 20 or the surface light-emitting body is maintained.

The "abrasion resistance" in the present specification is evaluated by the following method. Abrasion marks are formed on the optical film 20 by reciprocating a waste cloth 1000 times in total with a weight of 200 g for a distance of 300 mm at a speed of one reciprocation/min, using a rubbing tester (model name "RT-200," DAIEI KAGAKU SEIKI MFG. CO., LTD).

The abrasion evaluation is based on a value (%) obtained by subtracting the light extraction efficiency of the surface light-emitting body on which the optical film 20 is laminated before the rubbing test from the light extraction efficiency of the surface light-emitting body on which the optical film 20 is laminated after the rubbing test.

The abrasion resistance in the present embodiment is preferably -0.01% to 0.01%, more preferably -0.008% to 0.008%, and even more preferably -0.006% to 0.006%.

In order to make the β-region have the performance of abrasion resistance, it is desirable that the resin composition constituting the β-region include, for example, a monomer unit, which can impart abrasion resistance, such as a trifunctional or higher polyfunctional (meth)acrylate unit.

Examples of the monomer for constituting the trifunctional or higher polyfunctional (meth)acrylate unit include hexa(meth)acrylates such as dipentaerythritol hexa(meth)acrylate and caprolactone-modified dipentaerythritol hexa(meth)acrylate; penta(meth)acrylates such as dipentaerythritol penta(meth)acrylate, dipentaerythritol hydroxy penta(meth)acrylate, and caprolactone-modified dipentaerythritol hydroxy penta(meth)acrylate; tetra(meth)acrylates such as ditrimethylolpropane tetra(meth)acrylate, pentaerythritol tetra(meth)acrylate, pentaerythritol ethoxy-modified tetra(meth)acrylate, dipentaerythtol hexa(meth)acrylate, dipentaerythtol penta(meth)acrylate, and tetramethylolmethane tetra(meth)acrylate; and tri(meth)acrylates such as trimethylol propane tri(meth)acrylate, trisethoxylated trimethylol propane tri(meth)acrylate, pentaerythritol tri(meth)acrylate, ethoxylated pentaerythritol tri(meth)acrylate, tris(2-(meth)acryloyloxyethyl)isocyanurate, trimethylol propane tri(meth)acrylate modified with aliphatic hydrocarbon with 2 to 5 carbon atoms, and isocyanuric acid ethylene oxide-modified tri(meth)acrylate.

From the viewpoint that it is possible to suppress scratches of the optical film 20 and the optical performance of the optical film 20 or the surface light-emitting body is maintained, the content ratio of the monomer unit, which can impart abrasion resistance, to the total mass of the resin composition constituting the β-region is preferably 30% by mass or more, more preferably 30% by mass to 80% by mass, and even more preferably 40% by mass to 70% by mass.

When the β-region has an antifouling property, it is possible to suppress adhesion of dirt to the optical film 20 and the optical performance of the optical film 20 or the surface light-emitting body is maintained.

The "antifouling property" in the present specification is evaluated by the following method.

A static contact angle of pure water on the surface of the optical film 20 is measured by using a contact angle meter, and a case where the static contact angle is 90° or larger is considered to be excellent in the antifouling property.

In order to make the β-region have the performance of an antifouling property, it is desirable that the resin composition constituting the β-region include, for example, a compound having water/oil repellency such as a fluorine compound, a silicone compound, or a long-chain aliphatic compound.

Examples of the fluorine compound include polytetrafluoroethylene, polychlorotrifluoroethylene, polyvinylidene fluoride, polyvinyl fluoride, perfluoroalkoxy fluororesin, a tetrafluoroethylene/hexafluoropropylene copolymer, an ethylene/tetrafluoroethylene copolymer, and an ethylene/chlorotrifluoroethylene copolymer.

Examples of the silicone compound include tetramethyl orthosilicate, N-(2-aminomethyl)-3-aminopropyltrimethoxysilane trimethylsilyl azide, ethoxytrimethylsilane, [3 -(2,3 -epoxypropoxy)-propyl] -trimethoxysilane, octamethyl cyclotetrasiloxane, trichlorosilane, and tetrachlorosilane.

Examples of the long-chain aliphatic compound include eicosapentaenoic acid, linoleic acid, and oleic acid.

From the viewpoint that it is possible to suppress adhesion of dirt to the optical film 20 and the optical performance of the optical film 20 or the surface light-emitting body is maintained, the content ratio of the compound having water/oil repellency to the total mass of the resin composition constituting the β-region is preferably 0.1% by mass or more, more preferably 0.1% by mass to 10% by mass, and even more preferably 0.5% by mass to 5% by mass.

When the β-region has flame resistance, the spread of combustion of the optical film 20 can be suppressed or the optical film 20 can be self-extinguished.

The "flame resistance" in the present specification is evaluated by the following method.

In an inflammability test in conformity with UL94 Standard (product safety standards developed by Underwriters Laboratories Inc.), a case satisfying UL94HB or UL94V2 is considered to be excellent in flame resistance.

In order to make the β-region have the performance of flame resistance, it is desirable that the resin composition constituting the β-region include, for example, a compound having flame resistance such as a phosphoric acid ester compound or a halogen-containing compound.

Examples of the phosphoric acid ester compound include trimethyl phosphate, triethyl phosphate, tributyl phosphate, trioctyl phosphate, tributoxyethyl phosphate, triphenyl phosphate, tricresyl phosphate, cresyl diphenyl phosphate, octyldiphenyl phosphate, diisopropylphenyl phosphate, 2-naphthyl diphenyl phosphate, and cresyldi-2,6-xylenylphosphate.

Examples of the halogen-containing compound include tetrabromobisphenol A, decabromodiphenyl oxide, hexabromocyclododecane, octabromodiphenyl ether, bistribromophenoxyethane, ethylenebistetrabromophthalimide, tribromophenol, halogenated polystyrene, chlorinated polyolefin, and polyvinyl chloride.

From the viewpoint that the spread of combustion of the optical film 20 can be suppressed or the optical film 20 can be self-extinguished, the content ratio of the compound having flame resistance to the total mass of the resin composition constituting the β-region is preferably 1% by mass or more, even more preferably 1% by mass to 20% by mass, and even more preferably 3% by mass to 15% by mass.

When the β-region has an antistatic property, it is possible to suppress adhesion of dirt or dust to the optical film 20 due to static electricity or the like and the optical performance of the optical film 20 or the surface light-emitting body is maintained.

The "antistatic property" in the present specification is evaluated by a resistivity test in conformity with IEC 60093. Specifically, the evaluation is conducted by the following method.

The surface resistivity is measured by using a resistivity meter when the surface of the optical film 20 is subjected to application of a voltage of 500 V by using a ring probe and then is maintained for 60 seconds.

From the viewpoint that it is possible to suppress adhesion of dirt or dust to the optical film 20 due to static electricity or the like and the optical performance of the optical film 20 or the surface light-emitting body is maintained, the surface resistivity of the optical film 20 is preferably 10¹³ Ω/cm² or less, more preferably 10⁸ Ω/cm² to 10¹³ Ω/cm², and even more preferably 10⁹ Ω/cm² to 10¹² Ω/cm².

In order to make the β-region have the performance of an antistatic property, it is desirable that the resin composition constituting the β-region include, for example, at least one compound having conductivity of an ionic liquid, a quaternary ammonium compound, an ionic surfactant, and a conductive polymer. These compounds may be used alone or in combination of two or more kinds thereof. Among these compounds, from the viewpoint of having excellent dispersibility in a resin, an ionic liquid is preferable.

The ionic liquid indicates a salt present in a liquid form and is composed of an anion and a cation.

Examples of the anion of the ionic liquid include halogens, imides, amides, sulfates, and phosphates. These anions of the ionic liquid may be used alone or in combination of two or more kinds thereof. Among these anions of the ionic liquid, from the viewpoint of having an excellent antistatic property, imides, amides, and sulfates are preferable, and imides and sulfates are more preferable.

Examples of the halogens include tetrafluoroborate, hexafluorophosphate, chloride, tetrachloroaluminate, bromide, and iodide. These halogens may be used alone or in combination of two or more kinds thereof.

Examples of the imides include trifluoromethanesulfonimide. These imides may be used alone or in combination of two or more kinds thereof.

Examples of the amides include cyanamide and trifluoromethyl sulfonamide. These amides may be used alone or in combination of two or more kinds thereof.

Examples of the sulfates include butylsulfate, methylsulfate, ethylsulfate, hydrogen sulfate, octylsulfate, and alkylsulfate. These sulfates may be used alone or in combination of two or more kinds thereof.

Examples of the phosphates include butylphosphate. These phosphates may be used alone or in combination of two or more kinds thereof.

In addition to above-described examples, nitrate, thiocyanate, acetate, aminoacetate, lactate, and the like are exemplified.

Examples of the cation of the ionic liquid include ammonium salts, imidazolium salts, phosphonium salts, pyridinium salts, pyrrolidinium salts, pyrrolinium salts, and triazolium salts. These cations of the ionic liquid may be used alone or in combination of two or more kinds thereof. Among these cations of the ionic liquid, from the viewpoint of having an excellent antistatic property, ammonium salts and imidazolium salts are preferable, and ammonium salts are more preferable.

Examples of the ammonium salts include butyl trimethyl ammonium, ethyl diethyl propyl ammonium, 2-hydroxyethyl-triethyl ammonium, methyl-trioctyl ammonium, methyltrioctyl ammonium, tetrabutyl ammonium, tetraethyl ammonium, tetraheptyl ammonium, tributylmethyl ammonium, triethylmethyl ammonium, and tris(2-hydroxy)methyl ammonium. These ammonium salts may be used alone or in combination of two or more kinds thereof.

Examples of the imidazolium salts include 1-allyl-3-methylimidazolium, 1-benzyl-3-methylimidazolium, 1,3-bis(cyanomethyl)imidazolium, 1,3-bis(cyanopropyl)imidazolium, 1 -butyl-2,3 -dimethylimidazolium, 4-(3 -butyl)-1 - imidazolium, 1-(3 -cyanopropyl)-3 -methylimidazolium, 1 -ethyl-3 -methylimidazolium, 1-butyl-3-methylimidazolium, 1-decyl-3-methylimidazolium, 1,3-diethoxy imidazolium, 1,3-dimethoxy-2-methylimidazolium, 1-hexyl-3-methylimidazolium, 1-methyl-3-octylimidazolium, and 1-methyl-3-propylimidazolium. These imidazolium salts may be used alone or in combination of two or more kinds thereof.

Examples of the phosphonium salts include tetrabutylphosphonium, tributylmethylphosphonium, and tirhexyltetradecylphosphonium. These phosphonium salts may be used alone or in combination of two or more kinds thereof.

Examples of the pyridinium salts include 1-butyl-3-methylpyridinium, 1-butyl-4-methylpyridinium, 1-butylpyridinium, 1-ethylpyridinium, 1-(3-cyanopropyl)pyridinium, and 3-methyl-4-propylpyridinium. These pyridinium salts may be used alone or in combination of two or more kinds thereof.

Examples of the pyrrolidinium salts include 1-butyl-1-methylpyrrolidinium, 2-methylpyrrolidinium, and 3-phenylpyrrolidinium. These pyrrolidinium salts may be used alone or in combination of two or more kinds thereof.

Examples of the pyrrolinium salts include 2-acetylpyrrolinium, 3-acetylpyrrolinium, and 1-(2-nitrophenyl)pyrrolinium. These pyrrolinium salts may be used alone or in combination of two or more kinds thereof.

The ionic liquid may be a commercially available ionic liquid, and examples thereof include FC series manufactured by Sumitomo 3M Limited such as "FC-4400"; and Amino Ion AS series manufactured by NIPPON NYUKAZAI CO., LTD. such as "Amino Ion AS100," "Amino Ion AS300," or "Amino Ion AS400."

Examples of the quaternary ammonium compound include ammonium fluoride, ammonium chloride, ammonium bromide, ammonium iodide, ammonium hydroxide, and ammonium polyhalide.

Examples of the conductive polymer include polythiophene, polythiophene vinylene, poly(3-alkylthiophene), polyparaphenylene, polyparaphenylene vinylene, polyaniline, polypyrrole, and poly 3,4 ethylenedioxythiophene-polystyrene sulfonic acid (PEDOT-PSS).

Examples of the ionic surfactant include sodium cholate, sodium deoxycholate, sodium glycolate, sodium taurocholate, sodium taurodeoxycholate, sodium N-lauroyl sarcosinate, hexadecyltrimethyl ammonium bromide, and myristyltrimethyl ammonium bromide.

From the viewpoint that it is possible to suppress adhesion of dirt or dust to the optical film 20 due to static electricity or the like and the optical performance of the optical film 20 or the surface light-emitting body is maintained, the content ratio of the compound having conductivity to the total mass of the resin composition constituting the β-region is preferably 1% by mass or more, more preferably 1% by mass to 15% by mass, and even more preferably 3% by mass to 10% by mass.

When the β-region has weather resistance, it is possible to suppress the deterioration of the optical film 20 due to weather and the optical performance of the optical film 20 or the surface light-emitting body is maintained.

The "weather resistance" in the present specification is evaluated by the following method.

After the optical film 20 is exposed to light of an ultraviolet light wavelength range (295 nm to 450 nm) at 800 W/cm² for 350 hours, a case where the total light transmittance of the optical film 20 after exposure is 0.7 time to 1.5 times the total light transmittance of the optical film 20 before exposure is considered to be excellent in weather resistance.

In order to make the β-region have the performance of weather resistance, it is desirable that the resin composition constituting the β-region include, for example, a compound which suppresses deterioration due to weather, such as an ultraviolet absorbing agent, an ultraviolet scattering agent, a light stabilizer, or an antioxidizing agent.

Examples of the ultraviolet absorbing agent include a benzotriazole compound, a triazine compound, a benzophenone compound, and a benzoate compound.

Examples of the ultraviolet scattering agent include titanium oxide and zinc oxide.

Examples of the light stabilizer include a hindered amine compound and a phenol compound.

Examples of the antioxidizing agent include a phosphate compound, a sulfur compound, and an amine compound. The antioxidizing agent has a role of improving thermal stability or oxygen stability.

From the viewpoint that it is possible to suppress the deterioration of the optical film 20 due to weather and the optical performance of the optical film 20 or the surface light-emitting body is maintained, the content ratio of the compound, which suppresses the deterioration due to weather, to the total mass of the resin composition constituting the β-region is preferably 1% by mass or more, more preferably 1% by mass to 15% by mass, and even more preferably 3% by mass to 10% by mass.

Second fine particles may be included in the β-region. As the material, the volume average particle diameter, and the shape of the second fine particles included in the β-region, the same material, volume average particle diameter, and shape as those of the first fine particles included in the α-region described above can be used, and from the same reason, the same range is preferable.

The volume average particle diameter and the shapes of the materials of the first fine particles and the second fine particles may be the same as or different from each other.

Furthermore, the weight average molecular weight of the resin composition constituting the β-region is preferably 500 or more, more preferably 1000 to 10000000, and even more preferably 2000 to 5000000.

It is preferable that the resin composition constituting the α-region and the resin composition constituting the β-region be different from each other.

### (Method for Producing Resin Composition)

As the resin composition constituting the optical film of the invention, any resin compositions can be used within a range corresponding to any one of the embodiments described above.

As a method for producing a resin composition, for example, a method of mixing a desired compound, a method of polymerizing a desired monomer, a method of performing polymerization by dispersing a desired compound in a desired monomer, and the like are exemplified.

As a method for polymerizing a monomer, for example, a method of curing a thermosetting composition containing a monomer by heating, a method of curing an active energy ray curable composition containing a monomer by irradiation of an active energy ray, and the like are exemplified. Among these methods for producing the resin, the method of curing an active energy ray curable composition containing a monomer by irradiation of an active energy ray is preferable from the viewpoint of simple steps and rapid curing speed.

Examples of the active energy ray include ultraviolet rays, electron beams, X rays, infrared rays, and visible rays. Among these active energy rays, from the viewpoint of having an excellent curing property of an active energy ray curable composition and the viewpoint that deterioration of the optical film can be suppressed, ultraviolet rays and electron beams are preferable and ultraviolet rays are more preferable.

### (Configuration of Optical Film)

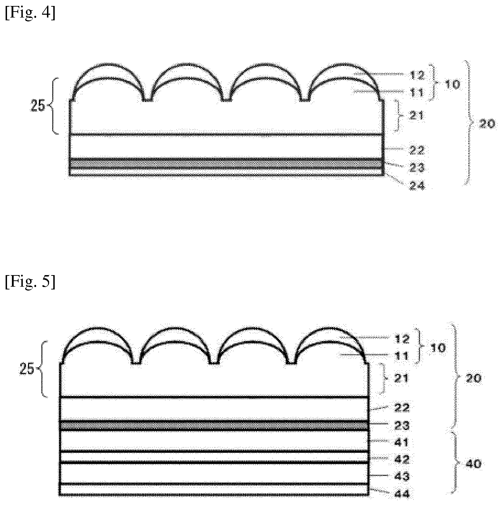

The optical film 20 according to an embodiment of the invention illustrated in Fig. 4 includes the base material 22, the convex microlens 10, the adhesive layer 23, and a protective film 24. The convex microlens 10 is disposed on the base material 22. The adhesive layer 23 and the protective film 24 are provided on the surface opposite to the surface of the base material 22 on which the convex microlens is disposed. The adhesive layer 23 is positioned between the base material 22 and the protective film 24.

From the viewpoint that the maintaining of the shape of the convex microlens 10 is excellent, it is preferable that the optical film of the invention be an optical film in which the base layer 21 is formed between the bottom surface portion of the convex microlens 10 and the base material 22 as illustrated in Fig. 4. However, the optical film of the invention is not limited thereto.

### (Base Layer)

The base layer 21 mainly has a function of maintaining the convex shape of the microlens 10 by buffering stress associated with polymerization shrinkage upon curing.

As a material of the base layer 21, known resins and the like are exemplified. Among these materials of the base layer 21, from the viewpoint of simple steps and the viewpoint that the adhesiveness with the base material 22 can be enhanced by making the base layer 21 and the convex microlens 10 an integrated continuous film-like body, the material of the base layer 21 is preferably the same as the material of the α-region 11. Incidentally, the base layer 21 and the α-region 11 may be collectively called the intermediate layer 25.

The thickness of the base layer 21 is preferably 1 µm to 60 µm, more preferably 3 µm to 40 µm, and even more preferably 5 µm to 30 µm. When the thickness of the base layer 21 is 1 µm or more, the handlability of the optical film is excellent. In addition, when the thickness of the base layer 21 is 60 µm or less, the light extraction efficiency of the surface light-emitting body is excellent.

### (Base Material)

In a case where the optical film, including the base material 22, is laminated on an organic EL element 40, the base material 22 is preferably formed by a material that easily transmits light of the visible light wavelength range. Specifically, regarding the visible light transmittance of the base material 18, a value measured in conformity with JIS K7361 is preferably 50% or more.

Furthermore, in a case where the active energy ray curable composition is interposed between the roll mold and the base material 22 and irradiated with an active energy ray during production of the optical film, the base material 22 is preferably formed by a material that easily transmits the active energy ray.

The material of the base material 22 includes acrylic resins; polycarbonate resins; polyester resins such as polyethylene terephthalate, polybutylene terephthalate, and polyethylene naphthalate; styrene resins such as polystyrene and an ABS resin; vinyl chloride resins; cellulose resins such as diacetyl cellulose and triacetyl cellulose; and imide resins such as polyimide and polyimideamide. These materials of the base material are used from the viewpoint of having excellent flexibility and an excellent light transmitting property for an active energy ray, wherein acrylic resins, polycarbonate resins, polyester resins, and imide resins are preferable, and polyester resins are more preferable.

The thickness of the base material 22 is preferably 10 µm to 500 µm, more preferably 20 µm to 400 µm, and even more preferably 50 µm to 300 µm. When the thickness of the base material is 10 µm or more, the handlability of the optical film is excellent. In addition, when the thickness of the base material is 500 µm or less, the light extraction efficiency of the surface light-emitting body is excellent.

### (Adhesive Layer 23)

In the optical film 20 of the invention, the adhesive layer 23 for adhering to an organic EL light-emitting element 30 may be provided on the surface not having the microlens 10. When the optical film 10 includes the base material 22, the adhesive layer 23 may be provided on the surface of the base material 22 as illustrated in Fig. 4.

As the adhesive layer 23, for example, a known adhesive or the like is exemplified.

In order to enhance the handlability of the optical film 10, the protective film 24 may be provided on the surface of the adhesive layer 23. The protective film 24 may be removed from the optical film 10 or the like at the time of attaching the optical film 10 or the like to the surface of the organic EL light-emitting element 30.

As the protective film 24, for example, a known protective film or the like is exemplified.

Further, a primer layer may be formed on the surface at the side on which the microlens 10 of the base material 22 is provided. That is, the primer layer may be formed between the base material 22 and the α-region.

When the primer layer is provided on the surface of the base material 22, the adhesiveness between the base material 22 and the α-region can be made stronger. Further, it is possible to improve film formability of the α-region.

Examples of a material of the primer layer include urethane resins such as an aqueous urethane resin, an acrylic type urethane resin, an ether type urethane resin, and a polyester type urethane resin. These materials of the primer layer may be used alone or in combination of two or more kinds thereof. Among these materials of the primer layer, from the viewpoint of having excellent adhesiveness between the base material 22 and the α-region, a urethane resin is preferable, and an acrylic type urethane resin is more preferable.

### (Method for Producing Optical Film)

As the method for producing the optical film of the invention, from the viewpoint of having simple steps and excellent formability of the optical film, a producing method including the following steps that are sequentially performed is preferable.

Step A: a step of, while a roll mold having an outer peripheral surface on which a plurality of concave microlens transferring portions are arranged is rotated and the base material is allowed to travel in a rotational direction of the roll mold along the outer peripheral surface of the roll mold, coating the outer peripheral surface of the roll mold with an active energy ray curable composition B to fill a part of the concave shapes of the microlens transferring portions with the active energy ray curable composition B

Step B: a step of supplying an active energy ray curable composition A to a space between the outer peripheral surface of the roll mold and the base material

Step C: a step of irradiating a region between the outer peripheral surface of the roll mold and the base material with an active energy ray in a state where the active energy ray curable composition A is interposed between the outer peripheral surface of the roll mold and the base material

Step D: a step of releasing cured products obtained in the above Step C from the roll mold

In other words, the method for producing the optical film includes: while a roll mold having an outer peripheral surface on which a plurality of concave microlens transferring portions are arranged is rotated and a base material is allowed to travel in a rotational direction of the roll mold along the outer peripheral surface of the roll mold, coating the outer peripheral surface of the roll mold with an active energy ray curable composition B to fill a part of the concave shapes of the microlens transferring portions with the active energy ray curable composition B; supplying an active energy ray curable composition A to a space between the outer peripheral surface of the roll mold and the base material; irradiating a region between the outer peripheral surface of the roll mold and the base material with an active energy ray in a state where at least the active energy ray curable composition A is interposed between the outer peripheral surface of the roll mold and the base material to obtain cured products of the active energy ray curable composition A and the active energy ray curable composition B; and releasing the cured products from the roll mold.

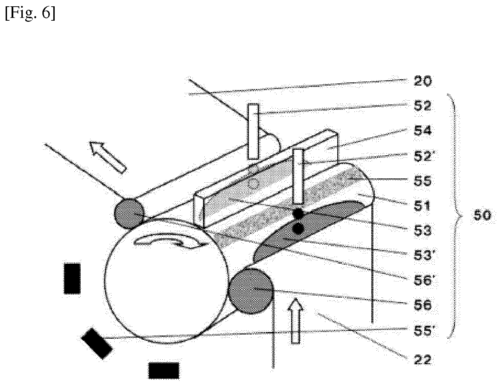

The producing method including Step A to Step D that are sequentially performed can be realized by, for example, using a producing apparatus illustrated in Fig. 6.

Hereinafter, the method for producing the optical film of the invention using the producing apparatus illustrated in Fig. 6 will be described, but the method for producing the optical film of the invention is not limited to the method using the producing apparatus illustrated in Fig. 6.

### (Step A)

Step A is a step of, while a roll mold 51 having an outer peripheral surface on which a plurality of concave microlens transferring portions are arranged is rotated and the base material 22 is allowed to travel in a rotational direction of the roll mold 51 (a direction of an arrow in Fig. 6) along the outer peripheral surface of the roll mold 51, coating the outer peripheral surface of the roll mold 51 with an active energy ray curable composition B to fill a part of the concave shapes of the microlens transferring portions with the active energy ray curable composition B.

Examples of the roll mold 51 include a metal mold of aluminum, yellow copper, steel, or the like; a resin mold of a silicone resin, a urethane resin, an epoxy resin, an ABS resin, a fluororesin, a polymethylpentene resin, or the like; a plated resin mold; and a mold produced with a material in which various metal powders are mixed with a resin. Among these roll molds 51, from the viewpoint of having excellent heat resistance and mechanical strength and having suitability for continuous production, a metal mold is preferable. Specifically, the metal mold is preferred in many aspects that it is resistant to heat generated by polymerization, hardly deformed, and resistant to scratches and it allows temperature control and is suitable for fine molding or the like.

The roll mold 51 has a transferring portion of a concave shape corresponding to the convex shape in order to form the convex microlenses on the optical film 20.

Examples of a method for producing a transferring portion include cutting by a diamond bite and etching as described in WO 2008/069324 A. Among these methods for producing a transferring portion, in the case of forming a concave shape with a curved face such as a spherical segment shape, etching as described in WO 2008/069324 A is preferable from the viewpoint of having excellent productivity of the roll mold 51, and in the case of forming a concave shape without a curved face such as a pyramid shape, cutting by a diamond bite is preferable from the viewpoint of having excellent productivity of the roll mold 51.

Furthermore, as a method for producing a transferring portion, it is possible to use a method of producing a roll mold of a cylindrical form by winding a metal thin film, which is produced from a master mold having a convex shape with reversed concave shape of the transferring portion by using electroforming, on a roll core member.

The rotation speed of the roll mold 51 is preferably 0.1 m/min to 50 m/min, more preferably 0.3 m/min to 40 m/min, and even more preferably 0.5 m/min to 30 m/min, from the viewpoint of having excellent formability and productivity of the optical film.

The travel speed of the base material 22 is preferably 0.1 m/min to 50 m/min, more preferably 0.3 m/min to 40 m/min, even more preferably 0.5 m/min to 30 m/min, from the viewpoint of having excellent formability and productivity of the optical film.

The rotation speed of the roll mold 51 and the travel speed of the base material 22 are preferably similar, from the viewpoint of having excellent formability of the optical film.

Examples of a method of coating the outer peripheral surface of the roll mold 51 with the active energy ray curable composition B include a method in which the active energy ray curable composition B is added dropwise to the roll mold 51 using a nozzle 52, and then is brought into contact with a doctor blade 54 to form a bank 53, and the active energy ray curable composition B is spread and coated in a width direction of the roll mold 51; a method in which the active energy ray curable composition B is added dropwise to the roll mold 51 using the nozzle 52, and the active energy ray curable composition B is spread and coated in the width direction of the roll mold 51 under pressure from a nip roll or an air curtain; and a method in which the active energy ray curable composition B is added dropwise to the doctor blade 54, and is brought to the outer peripheral surface of the roll mold 51 along the doctor blade 54 to form the bank 53, and the active energy ray curable composition B is spread and coated in the width direction of the roll mold 51. Among these method of applying the active energy ray curable composition B, from the viewpoint that it is possible to suppress the generation of air bubbles in the microlenses and the productivity of the optical film is excellent, the method in which the active energy ray curable composition B is added dropwise to the doctor blade 54, and is brought to the outer peripheral surface of the roll mold 51 along the doctor blade 54 to form the bank 53, and the active energy ray curable composition B is spread and coated in the width direction of the roll mold 51, is preferable.

Either a single (one) or a plurality of the nozzles 52 may be provided, but from the viewpoint that the active energy ray curable composition B can be evenly coated, a single (one) nozzle 52 is preferable.

From the viewpoint that the active energy ray curable composition B can be evenly coated upon applying of the active energy ray curable composition B, it is preferable to form the bank 53 on the outer peripheral surface of the roll mold 51.

The doctor blade 54 is effective for formation of the bank 53.

Examples of a material of the doctor blade 54 include resins such as polyethylene resin, polypropylene resin, and polyester resin; and metals such as aluminum and stainless steel. Among these materials of the doctor blade 54, from the viewpoint of having excellent flexibility and the viewpoint that it is possible to suppress scratches of the roll mold 51, resins are preferable, and particularly, polyester resin is preferable.

Instead of the doctor blade 54, a roll coater, a bar coater, and the like may be used.

In order to extract light emitted from the organic EL element more through the β-region to the outside, it is preferable that the surface of the α-region be covered with the β-region as much as possible. To that end, the application of the active energy ray curable composition B in Step A is preferably coating for making the active energy ray curable composition B follow a surface of the concave microlens transferring portion on the outer peripheral surface of the roll mold 51. Making the active energy ray curable composition B follow a surface of the concave microlens transferring portion upon coating means that the active energy ray curable composition B flows while being pressed against the surface of the microlens transferring portion, to thereby form a convex surface following at least a part of the surface of the microlens transferring portion.

As a method of coating that makes the active energy ray curable composition B follow the surface of the microlens transferring portion, for example, a method of forming the bank 53 of the active energy ray curable composition B while pressing the doctor blade 54 having a tapered sharp edge, a roll coater, or a bar coater against the surface of the rotating roll mold 51, and applying a shearing force to the active energy ray curable composition B by a peripheral edge portion of the concave microlens transferring portion as well as the doctor blade 54, the roll coater, or the bar coater, to thereby generate surface tension acting on the surface of the active energy ray curable composition B following the concave shape, is exemplified.

According to this, it is possible to suppress the generation of air bubbles in the optical film, the α-region can be covered with the β-region as much as possible, and the role of the β-region in the optical film can be sufficiently exerted.

The base material 22 is preferably pressed by a nip roll 56 and a hold-down roll 56' toward the roll mold 51, from the viewpoint that the thickness of the base layer can be controlled.

Examples of materials of the nip roll 56 and the hold-down roll 56' include a metal such as aluminum, stainless steel, or brass; and the above-described metal with a rubber layer on a surface thereof. Among these materials of the nip roll 56 and the hold-down roll 56', a metal with a rubber layer on a surface thereof is preferable.

Examples of a rubber material of the rubber layer include ethylene-propylene rubber, butadiene rubber, urethane rubber, nitrile rubber, and silicone rubber. Among these rubber materials of the rubber layer, from the viewpoint of having excellent active energy ray resistance, ethylene-propylene rubber and silicone rubber are preferable.

The rubber layer on the surfaces of the nip roll 56 and the hold-down roll 56' is preferably 20 to 90 degrees, more preferably 40 to 85 degrees, and even more preferably 50 to 80 degrees in rubber hardness defined by JIS-K-6253. When the rubber hardness of the rubber layer is 20 degrees or more, a suppression action of generation of air bubbles in the optical film is excellent. In addition, when the rubber hardness of the rubber layer is 90 degrees or less, a strain applied to the base material 22 is decreased and a suppression action of damage of the base material 22 is excellent.

In order to make the active energy ray curable composition B follow a concave surface of the outer peripheral surface of the roll mold 51, in addition to the above-described method, it is preferable to control the viscosity of the active energy ray curable composition B or the temperature during applying the active energy ray curable composition B. The reason for this is that, by controlling the viscosity or the temperature, a contact angle (wettability) upon contact between the concave shape of the outer peripheral surface of the roll mold 51 and the active energy ray curable composition B is determined and possibility of coating that follows the surface of the concave shape is determined. For example, there is a tendency that if the viscosity of the active energy ray curable composition B is too low, the active energy ray curable composition B stays only in a deep part of the concave shape and it is difficult to make follow the surface of the concave shape sufficiently, and if the viscosity of the active energy ray curable composition B is too high, the active energy ray curable composition B does not flow to the deep part of the concave shape and it is difficult to make follow the surface of the concave shape sufficiently.

The viscosity of the active energy ray curable composition B will be described later.

The temperature during applying the active energy ray curable composition B is preferably 10 to 90°C and more preferably 20 to 80°C, from the viewpoint that the active energy ray curable composition B can be coated to follow the surface of the concave shape of the outer peripheral surface of the roll mold 51.

The temperature during applying the active energy ray curable composition B may be controlled by providing heat source equipment such as a sheath heater and a hot water jacket as necessary, inside or outside the roll mold 51.

### (Step X)

In a case where it is desired to define an interface clearly between the α-region and the β-region in the microlens of the optical film 20, a step of irradiating the active energy ray curable composition B with an active energy ray to cure the active energy ray curable composition B (Step X) is preferably included before Step B.

Incidentally, in a case where there is no Step X, the vicinity of the interface between the α-region and the β-region in the microlens is gradated so that the vicinity of the interface between the α-region and the β-region becomes a region including components of both the α-region and the β-region.

As a method of irradiating with an active energy ray, for example, a method using an active energy ray irradiation device 55 is exemplified.

Irradiation of the active energy ray by the active energy ray irradiation device 55 is preferably performed uniformly in a width direction of the roll mold. Irradiation of the active energy ray that is uniform in the width direction of the roll mold can be realized, for example, by connecting a light incident end of a line light composed of optical fibers to an ultraviolet lamp and arranging a linear light exit end of the line light in the vicinity of the roll mold such that a line direction is the width direction of the roll mold.

The accumulated light quantity of the active energy ray by the active energy ray irradiation device 55 is preferably 0.01 J/cm² to 5 J/cm² and more preferably 0.1 J/cm² to 3 J/cm², from the viewpoint of having an excellent curing property of the active energy ray curable composition B and the viewpoint that the accumulated light quantity does not interfere with the coating of the active energy ray curable composition A.

A light shielding plate may be provided around the active energy ray irradiation device 55 as necessary, for preventing the active energy ray from the active energy ray irradiation device 55 from diffusing to cure the active energy ray curable composition A before being coated.

### (Step B)

Step B is a step of supplying the active energy ray curable composition A to a space between the outer peripheral surface of the roll mold 51 and the base material 22.

Examples of a method of supplying the active energy ray curable composition A to a space between the outer peripheral surface of the roll mold 51 and the base material 22 include a method in which the active energy ray curable composition A is added dropwise to the roll mold 51 coated with the active energy ray curable composition B using a nozzle 52', and then is brought into contact with the nip roll 56 through the base material 22 to form a bank 53', and the active energy ray curable composition A is spread and coated in the width direction of the roll mold 51; and a method in which the surface of the base material 22 is coated with the active energy ray curable composition A in advance, and then the roll mold 51 coated with the active energy ray curable composition B and the base material 22 coated with the active energy ray curable composition A are joined so as to perform coating. Among these methods of applying the active energy ray curable composition A, from the viewpoint that it is possible to suppress the generation of air bubble in the microlenses and it is easy to control the thickness of the base layer, the method in which the active energy ray curable composition A is added dropwise to the roll mold 51 coated with the active energy ray curable composition B using the nozzle 52', and then is brought into contact with the nip roll 56 through the base material 22 to form the bank 53', and the active energy ray curable composition A is spread and coated in the width direction of the roll mold 51, is preferable.

### (Step C)

Step C is a step of irradiating a region between the outer peripheral surface of the roll mold 51 and the base material 22 with an active energy ray in a state where at least the active energy ray curable composition A is interposed between the outer peripheral surface of the roll mold 51 and the base material 22.

As a method of irradiating with an active energy ray, for example, a method using an active energy ray irradiation device 55' is exemplified.

Examples of a source for emitting the active energy ray of the active energy ray irradiation device 55' include a chemical lamp, a low pressure mercury lamp, a high pressure mercury lamp, a metal halide lamp, an electrodeless ultraviolet lamp, a visible light halogen lamp, and a xenon lamp.

The accumulated light quantity of the active energy ray irradiated by the active energy ray irradiation device 55' is preferably 0.1 J/cm² to 10 J/cm² and more preferably 0.5 J/cm² to 8 J/cm², from the viewpoint of having an excellent curing property of the active energy ray curable composition and suppressing the deterioration of the optical film.

After Step C is finished, cured products of the active energy ray curable composition A and the active energy ray curable composition B are obtained.

### (Step D)

Step D is a step of releasing the cured products obtained in Step C from the roll mold 51.

For facilitating the releasing of the cured products from the roll mold 51, surface treatment may be performed on the outer peripheral surface of the roll mold 51 in advance.

Examples of a surface treatment method of the roll mold 51 include plating such as nickel plating, chrome plating, or diamond-like carbon coating; and a method of applying a mold release agent such as a fluorine mold release agent, a silicone mold release agent, or vegetable oil.

### (Active Energy Ray Curable Composition A and Active Energy Ray Curable Composition B)

The active energy ray curable composition A constitutes the α-region of the optical film by being cured by irradiation of the active energy ray.

The active energy ray curable composition A may be prepared by appropriately blending components described as the above-described α-region to form a desired α-region.

The active energy ray curable composition B constitutes the β-region of the optical film by being cured by irradiation of the active energy ray.

The active energy ray curable composition B may be prepared by appropriately blending components described as the above-described β-region to form a desired β-region.

The active energy ray curable composition A or the active energy ray curable composition B may contain other components as necessary.

Examples of the other compounds include various additives such as a release agent, a leveling agent, a dispersion stabilizer, and a viscosity modifier.

The viscosity of the active energy ray curable composition A is preferably 10 mPa·s to 3000 mPa·s, more preferably 20 mPa·s to 2500 mPa·s, and even more preferably 30 mPa·s to 2000 mPa·s, from the viewpoint of having excellent handlability at the time of producing the optical film.

The viscosity of the active energy ray curable composition B is preferably 10 mPa·s to 3000 mPa·s, more preferably 20 mPa·s to 2500 mPa·s, and even more preferably 30 mPa·s to 2000 mPa·s, from the viewpoint that it is possible to follow the concave surface of the outer peripheral surface of the roll mold 51 and the handlability at the time of producing the optical film is excellent.

From the viewpoint that it is easy to fill the active energy ray curable composition A and to control the ratios of the α-region and the β-region, the viscosity of the active energy ray curable composition B is preferably lower than the viscosity of the active energy ray curable composition A.

Incidentally, the method for the optical film of the invention by curing the active energy ray curable composition by an active energy ray is described in the above description. However, in the invention, similarly, it is also possible to obtain the optical film of the invention with a thermosetting composition in place of the active energy ray curable composition, by curing the thermosetting composition by heat in place of the active energy ray.

The above-described optical film 20 can be provided at the light emission side of a surface light-emitting body to be described later. Specifically, the optical film 20 can be provided at the light emission side of an organic EL light-emitting element so as to be used as a flat panel display or a lighting device.

### (Surface Light-Emitting Body)

A surface light-emitting body of the invention includes the optical film of the invention.

As the surface light-emitting body of the invention, for example, a surface light-emitting body as illustrated in Fig. 5 is exemplified.

Hereinafter, the surface light-emitting body as illustrated in Fig. 5 will be described, but the surface light-emitting body of the invention is not limited to the surface light-emitting body as illustrated in Fig. 5.

The surface light-emitting body illustrated in Fig. 5 includes an organic EL element 40 in which a glass substrate 41, a positive electrode 42, a light emitting layer 43, and a negative electrode 44 are sequentially laminated, and the optical film 20. The optical film 20 is provided on the surface opposite to the surface of the glass substrate 41 on which the organic EL element 40 is formed.

The surface light-emitting body in which the optical film 20 is provided on the organic EL element 40 is excellent in an optical property, particularly, light extraction efficiency. Furthermore, in the surface light-emitting body in which the optical film 20 is provided on the organic EL element 40, optical performance is sufficiently maintained since the optical film 20 is excellent in physical properties, particularly, impact resistance, abrasion resistance, an antifouling property, an antistatic property, and weather resistance.

Incidentally, according to an aspect of the optical film, the resin composition constituting the α-region includes a monomer unit having a bisphenol skeleton, a polyfunctional urethane (meth)acrylate unit, and a polyalkylene glycol di(meth)acrylate unit.

In the optical film, the content ratio of the monomer unit having a bisphenol skeleton to the total mass of the resin composition constituting the α-region is 10 to 80% by mass, the content ratio of the polyfunctional urethane (meth)acrylate unit to the total mass of the resin composition constituting the α-region is 10 to 60% by mass, and the content ratio of the polyalkylene glycol di(meth)acrylate unit to the total mass of the resin composition constituting the α-region is 10 to 50% by mass.

In the optical film, the content ratio of the monomer unit having a bisphenol skeleton to the total mass of the resin composition constituting the α-region is 20 to 65% by mass, the content ratio of the polyfunctional urethane (meth)acrylate unit to the total mass of the resin composition constituting the α-region is 20 to 50% by mass, and the content ratio of the polyalkylene glycol di(meth)acrylate unit to the total mass of the resin composition constituting the α-region is 15 to 40% by mass.

### EXAMPLES

Hereinafter, the invention will be described in detail by means of Examples, but the invention is not limited to these Examples.

### (Adhesion Test (Adhesiveness Evaluation))

The adhesion test is an adhesion test in conformity with ISO 2409, and specifically, the evaluation was conducted by the following method.

11 cuts reaching the base material 22 were formed on the optical film obtained in each of Examples and Comparative Examples using a cutter knife to form 100 grids of lattice pattern (cross cut). At this time, a dedicated cutter guide (trade name "No. 315 Super Cutter Guide," manufactured by Taiyu Kizai Co., Ltd.) was used. The interval of the cuts was set to 2 mm in this evaluation. An adhesive cellophane tape was pressed firmly onto the lattice pattern portion and the edge of the adhesive cellophane tape was peeled off at once at an angle of 45°. Thereafter, the state of the lattice pattern was compared with the standard drawing described in ISO 2409, and the adhesiveness was evaluated with six grades of class 0 to class 5. A case where a test result is class 0 indicates the highest adhesiveness, and a case where a test result is class 5 indicates the lowest adhesiveness.

### (Curling Property Test (Curling Property Evaluation))

The optical film obtained in each of Examples and Comparative Examples was cut into a size of 50 mm square, was dried at 60°C for 4 hours, was charge-removed by a blower for removal of electrostatic charge (model name "SJ-F020," manufactured by KEYENCE CORPORATION), and was left to stand still on a flat surface such that the surface having the microlens faces upward. In this state, distances from the flat surface to respective four corners of the optical film were measured by a height gauge (model name "HDS-H30C," manufactured by Mitutoyo Corporation).

The curling property evaluation was based on an average value (mm) of the distances of respective four corners.

### (Rubbing Test (Abrasion Evaluation))

Abrasion marks were formed on the optical film obtained in each of Examples and Comparative Examples by reciprocating a waste cloth 1000 times in total with a weight of 200 g for a distance of 300 mm at a speed of one reciprocation/min, using a rubbing tester (model name "RT-200," DAIEI KAGAKU SEIKI MFG. CO., LTD).

The abrasion evaluation was based on a value (%) obtained by subtracting the light extraction efficiency of the surface light-emitting body on which the optical film was laminated before the rubbing test from the light extraction efficiency of the surface light-emitting body on which the optical film was laminated after the rubbing test.

### (Resistivity Test (Antistatic Property Evaluation))

The surface resistivity was measured by using a resistivity meter (model name "Hiresta UP MCP-HT450 Type," manufactured by Mitsubishi Chemical Analytech Co., Ltd.) when the surface of the optical film obtained in each of Examples and Comparative Examples was subjected to application of a voltage of 500 V by using a ring probe (URS) and then was maintained for 60 seconds.

### (Measurement of Light Extraction Efficiency)

A 0.1 mm-thick light shielding sheet having a hole with a diameter of 10 mm was disposed on the surface light-emitting body, and this was disposed on a sample aperture of an integrating sphere (manufactured by Labsphere, Inc., 6 inch in size). In this state, light emitted from the hole with a diameter of 10 mm of the light shielding sheet when the organic EL element was turned on by allowing a current of 10 mA to flow into the organic EL element was measured by a spectroscopic instrument (spectroscope: model name "PMA-12" (manufactured by Hamamatsu Photonics K.K.), software: software name "U6039-01 ver. 3.3.1 basic software for PMA") and corrected by a standard luminosity curve, and the number of photons of the surface light-emitting body was calculated.

When the number of photons of the organic EL light-emitting element A was considered as 100%, a ratio (percentage) of the number of photons of the surface light-emitting body was considered as the light extraction efficiency (%).

### (Materials Used in Examples and Comparative Examples)

Resin composition A: a resin composition obtained by curing an active energy ray curable composition (1) to be described later by irradiation of an active energy ray

### (refractive index: 1.52)

Resin composition B: a resin composition obtained by curing an active energy ray curable composition (2) to be described later by irradiation of an active energy ray

### (refractive index: 1.52)

Resin composition C: a resin composition obtained by curing a mixture obtained by mixing 70% by mass of an active energy ray curable composition (1) to be described later and 30% by mass of fine particles A to be described later with respect to the total mass of a resin composition C, by irradiation of an active energy ray

Resin composition D: a resin composition obtained by curing a mixture obtained by mixing 70% by mass of an active energy ray curable composition (2) to be described later and 30% by mass of fine particles A to be described later with respect to the total mass of a resin composition D, by irradiation of an active energy ray

Resin composition E: a resin composition obtained by curing a mixture obtained by mixing 97% by mass of an active energy ray curable composition (1) to be described later and 3% by mass of an ionic liquid A with respect to the total mass of a resin composition E, by irradiation of an active energy ray

Resin composition F: a resin composition obtained by curing a mixture obtained by mixing 94% by mass of an active energy ray curable composition (1) to be described later and 6% by mass of an ionic liquid A with respect to the total mass of a resin composition F, by irradiation of an active energy ray

Resin composition G: a resin composition obtained by curing an active energy ray curable composition (3) to be described later with respect to the total mass of a resin composition G, by irradiation of an active energy ray

Fine particles A: silicone resin spherical fine particles (trade name "TSR9000," manufactured by Momentive Performance Materials Inc., refractive index: 1.42, volume average particle diameter: 2 µm)

Ionic liquid A: "Amino Ion AS100" (trade name, manufactured by NIPPON NYUKAZAI CO., LTD., a reaction product of alkanolamine and glycol sulfate ester)

Organic EL element A: an organic EL element in which the optical film on the surface of the light emitting surface side of an organic EL lighting panel kit "Symfos OLED-010K" (manufactured by KONICA MINOLTA, INC.) is removed

### (Production of Active Energy Ray Curable Composition (1))

To a glass flask, 117.6 g (0.7 mol) of hexamethylene diisocyanate and 151.2 g (0.3 mol) of isocyanurate-type hexamethylene diisocyanate trimer as a diisocyanate compound, 128.7 g (0.99 mol) of 2-hydroxypropylacrylate and 693 g (1.54 mol) of pentaerythritol triacrylate as hydroxyl group-containing (meth)acrylate, 22.1 g of di-n-butyltin dilaurate as a catalyst, and 0.55 g of hydroquinone monomethyl ether as a polymerization inhibitor were added. After raising the temperature to 75°C, the stirring was continued while the temperature was maintained to 75°C, and the reaction was allowed to occur until the concentration of the isocyanate compound remaining in the flask was 0.1 mol/L or less. As a result of cooling to room temperature, urethane polyfunctional acrylate was obtained.

34.6 parts by mass of the obtained urethane polyfunctional acrylate, 24.7 parts by mass of polybutylene glycol dimethacrylate (trade name "Acryester PBOM," manufactured by MITSUBISHI RAYON CO., LTD.), 39.5 parts by mass of ethylene oxide-modified bisphenol A dimethacrylate (trade name "New Frontier BPEM-10," manufactured by DKS Co. Ltd.), and 1.2 parts by mass of 1-hydroxycyclohexyl phenyl ketone (trade name "IRGACURE 184," manufactured by BASF Japan Ltd.) were mixed with one another to obtain an active energy ray curable composition (1).

### (Production of Active Energy Ray Curable Composition (2))

27.8 parts by mass of pentaerythrytol triacrylate (trade name "Viscoat 300," manufactured by Osaka Organic Chemical Industry Ltd.), 27.8 parts by mass of dipentaerythritol hexaacrylate (trade name "M400," manufactured by TOAGOSEI CO., LTD.), 27.8 parts by mass of 1,6-hexanediol diacrylate (trade name "Viscoat 230," manufactured by Osaka Organic Chemical Industry Ltd.), 9.3 parts by mass of urethane acrylate (trade name "UTP-601," manufactured by Osaka Organic Chemical Industry Ltd.), 1.9 parts by mass of (2,4,6-trimethylphenyl)(diphenylphosphinyl)ketone, and 5.4 parts by mass of 1-hydroxycyclohexyl phenyl ketone (trade name "IRGACURE 184," manufactured by BASF Japan Ltd.) were mixed with one another to obtain an active energy ray curable composition (2).

### (Production of Active Energy Ray Curable Composition (3))

30.0 parts by mass of urethane polyfunctional acrylate obtained by the same method as in the production of the active energy ray curable composition (1), 34.4 parts by mass of polybutylene glycol dimethacrylate (trade name "Acryester PBOM," manufactured by MITSUBISHI RAYON CO., LTD.), 34.6 parts by mass of ethylene oxide-modified bisphenol A dimethacrylate (trade name "New Frontier BPEM-10," manufactured by DKS Co. Ltd.), and 1.0 part by mass of 1-hydroxycyclohexyl phenyl ketone (trade name "IRGACURE 184," manufactured by BASF Japan Ltd.) were mixed with one another to obtain an active energy ray curable composition (3).

### (Production of Roll Mold)

On an outer peripheral surface of a steel roll with an outer diameter of 200 mm and an axial direction length of 320 mm, copper plating with a thickness of 200 µm and a Vickers hardness of 230 Hv was performed. The surface of the copper plating layer was coated with a sensitizer, and was subjected to laser light exposure, development, and etching, thereby obtaining a mold having a transferring portion formed therein, in which hemispherical concave shapes having a diameter of 50 µm and a depth of 25 µm are arranged on the copper plating layer in a hexagonal alignment manner at the minimum interval of 3 µm. On the surface of the obtained mold, chrome plating was performed to give an anti-corrosion property and durability, and thus a roll mold was obtained.

Incidentally, a width of a region in which the concave transferring portion is present on the roll mold is 280 mm, the region is provided at a center of 320 mm, which is the length of the roll mold in the axial direction, and both ends of the roll mold in the axial direction were made mirror plane regions.

### (Production of Surface Light-Emitting Body)

On the light emitting surface side of the organic EL element, Cargille standard refractive index liquid (refractive index of 1.52, manufactured by MORITEX Corporation) was coated as the adhesive layer 23. The surface of the base material of the optical film having the base material thus obtained was subjected to optical adhesion to thereby obtain a surface light-emitting body.

### [Example 1]

### (Production of Optical Film)

Using the active energy ray curable composition (1) as the active energy ray curable composition A for constituting the α-region, and the active energy ray curable composition (2) as the active energy ray curable composition B for constituting the β-region, an optical film was produced by performing Step A (the coating includes making the active energy ray curable composition B follow the surface of the concave microlens transferring portion), Step X, Step B, Step C, and Step D in this order, using the apparatus illustrated in Fig. 6. In the microlens of the optical film thus obtained, the α-region was formed by the resin composition A, the β-region was formed by the resin composition B, the average maximum diameter Lₐᵥₑ of the bottom surface portion of the microlens was 50 µm, the average height Hₐᵥₑ of the microlens was 25 µm, the average height hₐᵥₑ of the α-region was 18 µm, and the microlens had a spherical segment shape approximately corresponding to the size of the concave shape of the roll mold. In addition, the base layer of the optical film thus obtained was formed by the same component as that of the α-region and had a thickness of 20 µm.

The results of the adhesion test, the rubbing test, and the curling property test of the optical film thus obtained are shown in Table 1.

**[Table 1]**

| | Optical film | | Evaluation result | | |
|---|---|---|---|---|---|
| | α-region | β-region | Adhesion test (class) | Warpage test (mm) | Rubbing test (%) |
| Example 1 | Resin composition A | Resin composition B | 0 | 0.18 | 0.003 |
| Comparative Example 1 | Resin composition A | Resin composition A | 0 | 0.67 | -0.016 |
| Comparative Example 2 | Resin composition B | Resin composition B | 0 | 2.25 | -0.013 |

Incidentally, a polyester film (trade name "DIAFOIL T910E125," manufactured by Mitsubishi Plastics, Inc., 340 mm in width, 125 µm in thickness) was used as the base material 22, the above-described roll mold was used as the roll mold 51, a plastic doctor blade (trade name "Maniveil," manufactured by ECO BLADE, Inc., 0.35 mm in thickness, with tapered blade edge) was used as the doctor blade 54, an ultraviolet irradiation device (model name "SP-7," manufactured by USHIO INC.) was used as the active energy ray irradiation device 55, an ultraviolet irradiation device (model name "Light Hammer 6," manufactured by Fusion UV Systems Inc.) was used as the active energy ray irradiation device 55', and a rubber roller (trade name "Granpaul UV," manufactured by MIYAKAWA ROLLER Co., Ltd., 60 degrees in rubber hardness of surface) was used as the nip roll 56 and the hold-down roll 56'.

Furthermore, the production conditions were as follows.

The travel speed of the base material 22 was set to 3 m/min, the rotation speed of the roll mold 51 was set to 3 m/min, the surface temperature of the roll mold 51 was set to 40°C, the temperatures of the active energy ray curable composition A and the active energy ray curable composition B were set to 25°C, and the viscosities of the active energy ray curable composition A and the active energy ray curable composition B were set to 700 mPa·s.

As a method of applying the active energy ray curable composition B, a method in which the active energy ray curable composition B is added dropwise to the roll mold 51 using the nozzle 52, and then is brought into contact with the doctor blade 54 to form the bank 53, and the active energy ray curable composition B is spread and coated in the width direction of the roll mold 51 was used. In this application method, the active energy ray curable composition B was made to follow the surface of the concave microlens transferring portion on the outer peripheral surface of the roll mold 51.

As a method of supplying the active energy ray curable composition A, a method in which the active energy ray curable composition A is added dropwise to the roll mold 51 coated with the active energy ray curable composition B using the nozzle 52', and then is brought into contact with the nip roll 56 through the base material 22 to form the bank 53', and the active energy ray curable composition A is spread and coated in the width direction of the roll mold 51 was used.

An ultraviolet ray of 0.2 J/cm² in the accumulated light quantity was emitted from the active energy ray irradiation device 55 and an ultraviolet ray of 0.76 J/cm² in the accumulated light quantity was emitted from the active energy ray irradiation device 55'.

### [Comparative Examples 1 and 2]

An optical film was obtained by performing the same operation as in Example 1, except that the α-region and the β-region of the optical film were changed to be formed by resin compositions shown in Table 1.

The results of the adhesion test, the curling property test, and the rubbing test of the optical film thus obtained are shown in Table 1.

### [Example 2 and Comparative Examples 3 and 4]

An optical film was obtained by performing the same operation as in Example 1, except that the α-region and the β-region of the optical film were changed to be formed by resin compositions shown in Table 2.

The results of the adhesion test, the curling property test, and the rubbing test of the optical film thus obtained are shown in Table 2.

**[Table 2]**

| | Optical film | | Evaluation result | | |
|---|---|---|---|---|---|
| | α-region | β-region | Adhesion test (class) | Warpage test (mm) | Rubbing test (%) |
| Example 2 | Resin composition C | Resin composition D | 0 | 0.76 | 0.003 |
| Comparative Example 3 | Resin composition C | Resin composition C | 0 | 0.98 | -0.025 |
| Comparative Example 4 | Resin composition D | Resin composition D | 0 | 2.60 | -0.011 |

### [Example 3 and Comparative Examples 1 and 5]

An optical film was obtained by performing the same operation as in Example 1, except that the α-region and the β-region of the optical film were changed to be formed by resin compositions shown in Table 3.

The results of the adhesion test, the curling property test, and the resistivity test of the optical film thus obtained are shown in Table 3.

**[Table 3]**

| | Optical film | | Evaluation result | | |
|---|---|---|---|---|---|
| | α-region | β-region | Adhesion test (class) | Warpage test (mm) | Resistivity test (W/cm²) |
| Example 3 | Resin composition A | Resin composition E | 0 | 0.15 | 1× 10¹⁰ |
| Comparative Example 1 | Resin composition A | Resin composition A | 0 | 0.12 | 10¹⁴ or more |
| Comparative Example 5 | Resin composition E | Resin composition E | 3 | 0.14 | 8× 10⁸ |

### [Example 4 and Comparative Example 6]

An optical film was obtained by performing the same operation as in Example 1, except that the α-region and the β-region of the optical film were changed to be formed by resin compositions shown in Table 4.

The results of the adhesion test, the curling property test, and the resistivity test of the optical film thus obtained are shown in Table 4.

**[Table 4]**

| | Optical film | | Evaluation result | | |
|---|---|---|---|---|---|
| | α-region | β-region | Adhesion test (class) | Warpage test (mm) | Resistivity test (W/cm²) |
| Example 4 | Resin composition A | Resin composition F | 0 | 0.23 | 3× 10⁹ |
| Comparative Example 1 | Resin composition A | Resin composition A | 0 | 0.12 | 10¹⁴ or more |
| Comparative Example 6 | Resin composition F | Resin composition F | 4 | 0.21 | 4× 10⁸ |

### [Example 5 and Comparative Example 7]

An optical film was obtained by performing the same operation as in Example 1, except that the α-region and the β-region of the optical film were changed to be formed by resin compositions shown in Table 5.

The results of the adhesion test, the curling property test, and the resistivity test of the optical film thus obtained are shown in Table 5.

**[Table 5]**

| | Optical film | | Evaluation result | | |
|---|---|---|---|---|---|
| | α-region | β-region | Adhesion test (class) | Warpage test (mm) | Resistivity test (W/cm²) |
| Example 5 | Resin composition G | Resin composition F | 0 | 0.27 | 1× 10¹⁰ |
| Comparative Example 7 | Resin composition G | Resin composition G | 0 | 0.18 | 10¹⁴ or more |
| Comparative Example 6 | Resin composition F | Resin composition F | 4 | 0.21 | 4× 10⁸ |

### [Example 6]

An optical film was obtained by performing the same operation as in Example 1, except that the α-region and the β-region of the optical film were changed to be formed by resin compositions shown in Table 6.

The results of the adhesion test, the curling property test, and the rubbing test of the optical film thus obtained are shown in Table 6.

**[Table 6]**

| | Optical film | | Evaluation result | | |
|---|---|---|---|---|---|
| | α-region | β-region | Adhesion test (class) | Warpage test (mm) | Rubbing test (%) |
| Example 6 | Resin composition G | Resin composition B | 0 | 0.46 | 0.004 |
| Comparative Example 7 | Resin composition G | Resin composition G | 0 | 0.18 | -0.025 |
| Comparative Example 2 | Resin composition B | Resin composition B | 0 | 2.25 | -0.013 |

As seen from Table 1 and Table 2, the optical film of each of Example 1 and Example 2 included in the scope of the invention was excellent in all of a low curling property, adhesiveness, and abrasion resistance since the α-region has a low curing property and adhesiveness and the β-region has abrasion resistance. On the other hand, the optical film of each of Comparative Examples 1 to 4 in which the α-region and the β-region have only any performance of a low curling property, adhesiveness, and abrasion resistance was not excellent in all of a low curling property, adhesiveness, and abrasion resistance.

As seen from Table 3 to Table 5, the optical film of each of Example 3 to Example 5 included in the scope of the invention was excellent in all of a low curling property, abrasion resistance, and an antistatic property since the α-region has a low curling property and the β-region has abrasion resistance and an antistatic property. On the other hand, the optical film of each of Comparative Examples 1, 5, 6, and 7 in which the α-region and the β-region have only any performance of a low curling property, abrasion resistance, and an antistatic property was not excellent in all of a low curling property, abrasion resistance, and an antistatic property.

As seen from Table 6, the optical film of Example 6 included in the scope of the invention was excellent in all of a low curling property, adhesiveness, and abrasion resistance since the α-region has a low curing property and adhesiveness and the β-region has abrasion resistance and an antistatic property. On the other hand, the optical film of each of Comparative Examples 2 and 7 in which the α-region and the β-region have only any performance of a low curling property, adhesiveness, and abrasion resistance was not excellent in all of a low curling property, adhesiveness, and abrasion resistance.

### INDUSTRIAL APPLICABILITY

According to the optical film of the invention, it is possible to obtain a surface light-emitting body which is excellent in an optical property, particularly, light extraction efficiency, and this surface light-emitting body can be used suitably for, for example, lighting devices, displays, or screens.

### EXPLANATIONS OF LETTERS OR NUMERALS

- 10: MICROLENS
- 11: α-REGION
- 12: β-REGION
- 13: BOTTOM SURFACE PORTION
- 20: OPTICAL FILM
- 21: BASE LAYER
- 22: BASE MATERIAL
- 23: ADHESIVE LAYER
- 24: PROTECTIVE FILM
- 25: INTERMEDIATE LAYER
- 40: ORGANIC EL ELEMENT
- 41: GLASS SUBSTRATE
- 42: POSITIVE ELECTRODE
- 43: LIGHT EMITTING LAYER
- 44: NEGATIVE ELECTRODE
- 50: PRODUCING APPARATUS FOR OPTICAL FILM
- 51: ROLL MOLD
- 52: NOZZLE
- 52': NOZZLE
- 53: BANK
- 53': BANK
- 54: DOCTOR BLADE
- 55: ACTIVE ENERGY RAY IRRADIATION DEVICE
- 55': ACTIVE ENERGY RAY IRRADIATION DEVICE
- 56: NIP ROLL
- 56': NIP ROLL

## Claims

1. An optical film comprising a base material and a plurality of convex microlenses arranged on the base material, the microlens having an α-region and a β-region, the β-region occupying the outer portion of the convex shape of the microlens and being positioned so as to cover the α-region, wherein
a resin composition constituting the α-region has a test result of class 0 or class 1 in an adhesion test in conformity with ISO 2409 for measuring adhesiveness between the base material and the resin composition constituting the α-region,
an average value of curls at four corners when the 50 mm-square optical film is dried at 60°C for 4 hours is 1.0 mm or less,
a resin composition constituting the α-region includes at least one unit selected from the group consisting of a polyoxyalkylene glycol di(meth)acrylate unit, a polyester polyol di(meth)acrylate unit, and an aromatic ester diol di(meth)acrylate unit, and
the base material is made from one selected from the group consisting of an acrylic resin, a polycarbonate resin, a polyester resin, a styrene resin, a vinyl chloride resin, a cellulose resin, and an imide resin.

2. The optical film according to claim 1, wherein the resin composition constituting the α-region further includes at least one unit selected from the group consisting of a monomer unit having a bisphenol skeleton and a polyfunctional urethane (meth)acrylate unit.

3. The optical film according to claim 1 or 2, further comprising a primer layer including a urethane resin between the base material and the microlens.

4. The optical film according to claim 1, wherein the total content ratio of the polyoxyalkylene glycol di(meth)acrylate unit, the polyester polyol di(meth)acrylate unit, and the aromatic ester diol di(meth)acrylate unit to the total mass of the resin composition constituting the α-region is 10% by mass or more.

5. The optical film according to claim 1, wherein
a difference in light extraction efficiency of a surface light-emitting body before and after a rubbing test of reciprocating a waste cloth 1000 times with a weight of 200 g on the β-region of the optical film is -0.01% to 0.01%.

6. The optical film according to claim 5, wherein a resin composition constituting the β-region includes a trifunctional or higher polyfunctional (meth)acrylate unit.

7. The optical film according to claim 6, wherein the trifunctional or higher polyfunctional (meth)acrylate unit is at least one trifunctional or higher polyfunctional (meth)acrylate unit selected from the group consisting of pentaerythritol tri(meth)acrylate, dipentaerythritol penta(meth)acrylate, dipentaerythritol hexa(meth)acrylate, and tris(2-(meth)acryloyloxyethyl) isocyanurate.

8. The optical film according to claim 6 or 7, wherein a content ratio of the trifunctional or higher polyfunctional (meth)acrylate unit to the total mass of the resin composition constituting the β-region is 30% by mass or more.

9. The optical film according to claim 1, wherein
a surface resistance value of the β-region in a resistivity test in conformity with IEC 60093 is 10¹³ Ω/cm² or less.

10. The optical film according to claim 9, wherein a resin composition constituting the β-region includes at least one material selected from the group consisting of an ionic liquid, a quaternary ammonium compound, an ionic surfactant, and a conductive polymer.

11. The optical film according to claim 10, wherein the resin composition constituting the β-region includes an ionic liquid.

12. A method for producing the optical film according to any one of claims 1 to 11, the method comprising:
while a roll mold having an outer peripheral surface on which a plurality of concave microlens transferring portions are arranged is rotated and a base material is allowed to travel in a rotational direction of the roll mold along the outer peripheral surface of the roll mold, coating the outer peripheral surface of the roll mold with an active energy ray curable composition B to fill a part of the concave shapes of the microlens transferring portions with the active energy ray curable composition B;
supplying an active energy ray curable composition A to a space between the outer peripheral surface of the roll mold and the base material;
irradiating a region between the outer peripheral surface of the roll mold and the base material with an active energy ray in a state where at least the active energy ray curable composition A is interposed between the outer peripheral surface of the roll mold and the base material to obtain cured products of the active energy ray curable composition A and the active energy ray curable composition B; and
releasing the cured products from the roll mold.

13. The method for producing the optical film according to claim 12, wherein the application of the active energy ray curable composition B in the filling with the active energy ray curable composition B is coating for making the active energy ray curable composition B follow a surface of the concave microlens transferring portion on the outer peripheral surface of the roll mold.

14. The method for producing the optical film according to claim 12 or 13, further comprising irradiating the active energy ray curable composition B with an active energy ray to cure the active energy ray curable composition B between the filling with the active energy ray curable composition B and the supplying of the active energy ray curable composition A.

15. The method for producing the optical film according to any one of claims 12 to 14, wherein a viscosity of the active energy ray curable composition B is lower than a viscosity of the active energy ray curable composition A.

16. A surface light-emitting body comprising the optical film according to any one of claims 1 to 11.

## Patentansprüche

1. Optischer Film, umfassend ein Basismaterial und eine Mehrzahl von konvexen Mikrolinsen, die auf dem Basismaterial angeordnet sind, wobei die Mikrolinse einen α-Bereich und einen β-Bereich aufweist, wobei der β-Bereich den äußeren Abschnitt der konvexen Form der Mikrolinse einnimmt und so positioniert ist, dass er den α-Bereich bedeckt, wobei
eine Harzzusammensetzung, die den α-Bereich bildet, ein Testergebnis der Klasse 0 oder Klasse 1 in einer Haftfestigkeitsprüfung nach ISO 2409 zur Messung der Haftfestigkeit zwischen dem Basismaterial und der Harzzusammensetzung, die den α-Bereich bildet, aufweist,
ein durchschnittlicher Wert von Kräuselungen an vier Ecken, wenn der 50 mm quadratische optische Film 4 Stunden lang bei 60°C getrocknet wird, 1,0 mm oder weniger beträgt,
eine Harzzusammensetzung, die den α-Bereich bildet, zumindest eine Einheit enthält, die ausgewählt ist aus der Gruppe bestehend aus einer Polyoxyalkylenglykoldi(meth)acrylateinheit, einer Polyesterpolyoldi(meth)acrylateinheit und einer aromatischen Esterdioldi(meth)acrylateinheit besteht, und
das Basismaterial aus einem aus der Gruppe bestehend aus einem Acrylharz, einem Polycarbonatharz, einem Polyesterharz, einem Styrolharz, einem Vinylchloridharz, einem Celluloseharz und einem Imidharz ausgewählt ist.

2. Optischer Film nach Anspruch 1, wobei die Harzzusammensetzung, die den α-Bereich bildet, ferner zumindest eine Einheit enthält, die ausgewählt ist aus der Gruppe bestehend aus einer Monomereinheit mit einem Bisphenolgerüst und einer polyfunktionellen Urethan(meth)acrylateinheit besteht.

3. Optischer Film nach Anspruch 1 oder 2, ferner umfassend eine Primerschicht, die ein Urethanharz zwischen dem Basismaterial und der Mikrolinse enthält.

4. Optischer Film nach Anspruch 1, wobei das Gesamtgehaltsverhältnis der Polyoxyalkylenglykoldi(meth)acrylateinheit, der Polyesterpolyoldi(meth)acrylateinheit und der aromatischen Esterdioldi(meth)acrylateinheit zur Gesamtmasse der Harzzusammensetzung, die den α-Bereich bildet, 10 Massen-% oder mehr beträgt.

5. Optischer Film nach Anspruch 1, wobei
eine Differenz in der Lichtextraktionseffizienz eines Oberflächenlichtemittierenden Körpers vor und nach einem Reibetest von 1000-mal Hin- und Herbewegen eines Abfallstofftuchs mit einem Gewicht von 200 g auf dem β-Bereich des optischen Films -0,01% bis 0,01% beträgt.

6. Optischer Film nach Anspruch 5, wobei eine Harzzusammensetzung, die den β-Bereich bildet, eine trifunktionelle oder höhere polyfunktionelle (Meth)acrylateinheit enthält.

7. Optischer Film nach Anspruch 6, wobei die trifunktionelle oder höhere polyfunktionelle (Meth)acrylateinheit zumindest eine trifunktionelle oder höhere polyfunktionelle (Meth)acrylateinheit ist, die ausgewählt ist aus der Gruppe bestehend aus Pentaerythritoltri(meth)acrylat, Dipentaerythritolpenta(meth)acrylat, Dipentaerythritolhexa(meth)acrylat und Tris(2-(meth)acryloyloxyethyl)isocyanurat.

8. Optischer Film nach Anspruch 6 oder 7, wobei ein Gehaltsverhältnis der trifunktionalen oder höheren polyfunktionellen (Meth)acrylateinheit zur Gesamtmasse der Harzzusammensetzung, die den β-Bereich bildet, 30 Massen-% oder mehr beträgt.

9. Optischer Film nach Anspruch 1, wobei
ein Oberflächenwiderstandswert des β-Bereichs in einer Widerstandsprüfung nach IEC 60093 ist 10¹³ Ω/cm² oder weniger beträgt.

10. Optischer Film nach Anspruch 9, wobei eine Harzzusammensetzung, die den β-Bereich bildet, zumindest ein Material enthält, das ausgewählt ist aus der Gruppe bestehend aus einer ionischen Flüssigkeit, einer quartären Ammoniumverbindung, einem ionischen Tensid und einem leitfähigen Polymer.

11. Optischer Film nach Anspruch 10, wobei die Harzzusammensetzung, die den β-Bereich bildet, eine ionische Flüssigkeit beinhaltet.

12. Verfahren zum Herstellen des optischen Films nach einem der Ansprüche 1 bis 11, wobei das Verfahren umfasst:
während eine Walzenform mit einer äußeren Umfangsfläche, auf der mehrere konkave Mikrolinsenübertragungsabschnitte angeordnet sind, gedreht wird und ein Basismaterial in einer Drehrichtung der Walzenform entlang der äußeren Umfangsfläche der Walzenform laufen gelassen wird, Beschichten der äußeren Umfangsfläche der Walzenform mit einer durch aktive Energiestrahlung härtbaren Zusammensetzung B, um einen Teil der konkaven Formen der Mikrolinsenübertragungsabschnitte mit der durch aktive Energiestrahlung härtbaren Zusammensetzung B zu füllen;
Zuführen einer durch aktive Energiestrahlung härtbaren Zusammensetzung A zu einem Raum zwischen der äußeren Umfangsfläche der Walzenform und dem Basismaterial;
Bestrahlen eines Bereichs zwischen der äußeren Umfangsfläche der Walzenform und dem Basismaterial mit einer aktiven Energiestrahlung in einem Zustand, in dem zumindest die durch aktive Energiestrahlung härtbare Zusammensetzung A zwischen der äußeren Umfangsfläche der Walzenform und dem Basismaterial angeordnet ist, um gehärtete Produkte der durch aktive Energiestrahlung härtbaren Zusammensetzung A und der durch aktive Energiestrahlung härtbaren Zusammensetzung B zu erhalten; und
Freisetzen der gehärteten Produkte aus der Walzenform.

13. Verfahren zum Herstellen des optischen Films nach Anspruch 12, wobei das Aufbringen der durch aktive Energiestrahlung härtbaren Zusammensetzung B beim Füllen mit der durch aktive Energiestrahlung härtbaren Zusammensetzung B ein Beschichten ist, um die durch aktive Energiestrahlung härtbare Zusammensetzung B einer Oberfläche des konkaven Mikrolinsenübertragungsabschnitts auf der äußeren Umfangsfläche der Walzenform folgen zu lassen.

14. Verfahren zum Herstellen des optischen Films nach Anspruch 12 oder 13, ferner umfassend das Bestrahlen der durch aktive Energiestrahlung härtbaren Zusammensetzung B mit einer aktiven Energiestrahlung, um die durch aktive Energiestrahlung härtbare Zusammensetzung B zwischen dem Füllen mit der durch aktive Energiestrahlung härtbaren Zusammensetzung B und dem Zuführen der durch aktive Energiestrahlung härtbaren Zusammensetzung A zu härten.

15. Verfahren zum Herstellen des optischen Films nach einem der Ansprüche 12 bis 14, wobei eine Viskosität der durch aktive Energiestrahlung härtbaren Zusammensetzung B niedriger ist als eine Viskosität der durch aktive Energiestrahlung härtbaren Zusammensetzung A.

16. Oberflächenlichtemittierender Körper, umfassend den optischen Film nach einem der Ansprüche 1 bis 11.

## Revendications

1. Film optique comprenant un matériau de base et une pluralité de microlentilles convexes disposées sur le matériau de base, la microlentille ayant une zone α et une zone β, la zone β occupant la partie externe de la forme convexe de la microlentille et étant positionnée de façon à recouvrir la zone α, dans lequel
une composition de résine constituant la zone α possède un résultat de test de classe 0 ou de classe 1 dans le cadre d'un test d'adhérence conforme à la norme ISO 2409 destiné à mesurer l'adhérence entre le matériau de base et la composition de résine constituant la zone α,
une valeur moyenne d'enroulement aux quatre angles lorsque le film optique de 50 mm² est séché à 60 °C pendant 4 heures est de 1 mm ou moins,
une composition de résine constituant la zone α comprend au moins une unité choisie parmi le groupe consistant en une unité de di(méth)acrylate de glycol polyoxyalkylène, une unité de di(méth)acrylate de polyol de polyester, et une unité de di(méth)acrylate de diol d'ester aromatique, et
le matériau de base est composé d'un matériau choisi parmi le groupe consistant en une résine acrylique, une résine de polycarbonate, une résine de polyester, une résine de styrène, une résine de chlorure de vinyle, une résine de cellulose, et une résine d'imide.

2. Film optique selon la revendication 1, dans lequel la composition de résine constituant la zone α comprend en outre au moins une unité choisie parmi le groupe consistant en une unité de monomère ayant un squelette de bisphénol et une unité de (méth)acrylate d'uréthane polyfonctionnel.

3. Film optique selon la revendication 1 ou 2, comprenant en outre une couche d'amorce qui comprend une résine d'uréthane entre le matériau de base et la microlentille.

4. Film optique selon la revendication 1, dans lequel le rapport entre la teneur totale en unité de di(méth)acrylate de glycol de polyoxoalkylène, en unité de di(méth)acrylate de polyol de polyester, et en unité de di(méth)acrylate d'ester aromatique et la masse totale de composition de résine constituant la zone α est de 10 % en poids ou plus.

5. Film optique selon la revendication 1, dans lequel une différence d'efficacité d'extraction de lumière d'un corps électroluminescent de surface avant et après un test de frottement qui consiste à frotter un chiffon 1 000 fois avec un poids de 200 g sur la zone β du film optique est de -0,01% à 0,01%.

6. Film optique selon la revendication 5, dans lequel une composition de résine constituant la zone β comprend une unité de (méth)acrylate polyfonctionnel trifonctionnelle ou plus.

7. Film optique selon la revendication 6, dans lequel l'unité de (méth)acrylate polyfonctionnel trifonctionnelle ou plus est au moins une unité de (méth)acrylate polyfonctionnel trifonctionnelle ou plus choisie parmi le groupe consistant en du tri(méth)acrylate de pentaérythritol, du penta(méth)acrylate de dipentaérythritol, du hexa(méth)acrylate de dipentaérythritol, et de l'isocyanurate de tris(2-(méth)acryloyloxyéthyle).

8. Film optique selon la revendication 6 ou 7, dans lequel un rapport entre la teneur en unité de (méth)acrylate polyfonctionnel trifonctionnelle ou plus et la masse totale de composition de résine constituant la zone β est de 30% en poids ou plus.

9. Film optique selon la revendication 1, dans lequel une valeur de résistance de surface de la zone β dans le cadre d'un test de résistivité conforme à la norme IEC 60093 est de 10¹³ Ω/cm² ou moins.

10. Film optique selon la revendication 9, dans lequel une composition de résine constituant la zone β comprend au moins un matériau choisi parmi le groupe consistant en un liquide ionique, un composé d'ammonium quaternaire, un tensioactif ionique, et un polymère conducteur.

11. Film optique selon la revendication 10, dans lequel la composition de résine constituant la zone β comprend un liquide ionique

12. Procédé de fabrication du film optique selon l'une quelconque des revendications 1 à 11, le procédé comprenant :
pendant qu'un moule de roulage ayant une surface périphérique externe sur laquelle une pluralité de parties de transfert de microlentilles concaves est disposée est tourné et un matériau de base se déplace dans une direction de rotation du moule de roulage le long de la surface périphérique externe du moule de roulage, le recouvrement de la surface périphérique externe du moule de roulage avec une composition B qui peut durcir sous des rayons d'énergie active afin de remplir une partie des formes concaves des parties de transfert de microlentilles avec la composition B qui peut durcir sous des rayons d'énergie active ;
la fourniture d'une composition A qui peut durcir sous des rayons d'énergie active à un espace situé entre la surface périphérique externe du moule de roulage et le matériau de base ;
l'irradiation d'une zone située entre la surface périphérique externe du moule de roulage et le matériau de base avec un rayon d'énergie active dans un état dans lequel au moins la composition A qui peut durcir sous des rayons d'énergie active est interposée entre la surface périphérique externe du moule de roulage et le matériau de base afin d'obtenir des produits durcis composés de la composition A qui peut durcir sous des rayons d'énergie active et de la composition B qui peut durcir sous des rayons d'énergie active ; et
la libération des produits durcis du moule de roulage.

13. Procédé de fabrication du film optique selon la revendication 12, dans lequel l'application de la composition B qui peut durcir sous des rayons d'énergie active lors du remplissage avec la composition B qui peut durcir sous des rayons d'énergie active est une application destinée à ce que la composition B qui peut durcir sous des rayons d'énergie active suive une surface de la partie de transfert de microlentille concave sur la surface périphérique externe du moule de roulage.

14. Procédé de fabrication du film optique selon la revendication 12 ou 13, comprenant en outre l'irradiation de la composition B qui peut durcir sous des rayons d'énergie active avec un rayon d'énergie active afin de faire durcir la composition B qui peut durcir sous des rayons d'énergie active entre le remplissage avec la composition B qui peut durcir sous des rayons d'énergie active et la fourniture de la composition A qui peut durcir sous des rayons d'énergie active.

15. Procédé de fabrication du film optique selon l'une quelconque des revendications 12 à 14, dans lequel une viscosité de la composition B qui peut durcir sous des rayons d'énergie active est inférieure à une viscosité de la composition A qui peut durcir sous des rayons d'énergie active.

16. Corps électroluminescent de surface comprenant le film optique selon l'une quelconque des revendications 1 à 11.
